# EUROPEAN PATENT APPLICATION

(11) **EP 4 622 413 A1**
(43) Date of publication of application: **24.09.2025**
(21) Application number: 24814438.8
(22) Date of filing: 28.05.2024
(51) Int. Cl.: H05K 7/20

(54) **LIQUID COOLING MODULE, ELECTRONIC DEVICE AND FITTING**

(30) Priority: 30.05.2023 CN 202310630409
(71) Applicant: Huawei Technologies Co., Ltd., Shenzhen, Guangdong 518129 (CN)
(72) Inventor: JIN, Linfang, Shenzhen, Guangdong 518129 (CN); TIAN, Xiangyu, Shenzhen, Guangdong 518129 (CN); FANG, Haoming, Shenzhen, Guangdong 518129 (CN); WANG, Yingxian, Shenzhen, Guangdong 518129 (CN)
(74) Representative: Pfenning, Meinig & Partner mbB
(86) International application number: PCT/CN2024/095822
(87) International publication number: WO 2024/245241

(57) **Abstract**

A liquid cooling module, an electronic device, and an accessory are provided. The liquid cooling module includes a pump, a liquid cooling component, and a working substance. The liquid cooling component includes a cavity. The working substance includes a first medium and a second medium, and a liquid-liquid interface exists between the first medium and the second medium. In the liquid cooling module, the pump communicates with the cavity, and the pump may drive the working substance in the cavity to flow. In a flowing process, the liquid-liquid interface of the working substance moves relative to the cavity, so that the working substance has a flow visualization effect. A visible light transmittance of at least a partial area of the liquid cooling component is greater than or equal to a threshold, so that a flow visualization effect of the working substance can be displayed through the area. The first medium used in the liquid cooling module has good heat dissipation performance, and the liquid cooling module has good heat dissipation performance. The liquid cooling module may be embedded in a housing of the electronic device, and an area in which a visible light transmittance of the housing is greater than or equal to the threshold at least partially overlaps an area in which a visible light transmittance of the liquid cooling component is greater than or equal to the threshold, so that the electronic device achieves a flow visualization effect.

## Description

This application claims priority to Chinese Patent Application No. 202310630409.0, filed with the China National Intellectual Property Administration on May 30, 2023 and entitled "LIQUID COOLING MODULE, ELECTRONIC DEVICE, AND ACCESSORY", which is incorporated herein by reference in its entirety.

### TECHNICAL FIELD

This application relates to the field of electronic device technologies, and in particular, to a liquid cooling module, an electronic device, and an accessory.

### BACKGROUND

A liquid cooling module may include a pump and a working substance. The working substance (working substance) may be understood as a carrier for mutual conversion between thermal energy and mechanical energy. The pump may be used as a power source for the working substance to provide flowing power for the working substance. In a flowing process, the working substance may be used as a carrier for heat transfer, so that the liquid cooling module can achieve a heat dissipation effect.

In recent years, flowing preparation of the working substance presents a visualization effect, so that a flow display area with a sense of science and technology can be implemented. A working substance whose flow status is visible and that is disclosed in the related technology includes water and a dye. The dye may color the working substance, so that a flowing process of the working substance may present a flow visualization effect.

A colored working substance may present the flow visualization effect in a liquid cooling module with a large size. A size of a liquid cooling module used in an electronic device is small (a cavity size of the liquid cooling module is usually on the microliter-scale). As a result, the flow visualization effect of the working substance disclosed in the related technology in the electronic device is poor.

### SUMMARY

This application discloses a liquid cooling module, an electronic device, and an accessory. A working substance of the liquid cooling module includes a first medium and a second phase. A liquid-liquid interface exists between the first medium and the second phase, and the pump may provide flowing power for the working substance. In a flowing process of the working substance, the liquid-liquid interface of the working substance moves relative to a cavity, so that the working substance has a flow visualization effect.

A first aspect of this application discloses a liquid cooling module, including a pump, a liquid cooling component, and a working substance. The liquid cooling component includes a cavity, and a visible light transmittance of at least a partial area of the liquid cooling component is greater than or equal to a threshold; the working substance is filled in the cavity; and the working substance includes a first medium and a second phase. A liquid-liquid interface exists between the second phase and the first medium. The pump communicates with the cavity, and is configured to drive the working substance in the cavity to flow, so that the liquid-liquid interface of the working substance moves relative to the cavity.

In this implementation, the pump communicates with the cavity, and the pump may provide flowing power for the working substance in a liquid cavity. In a flowing process of the working substance, the liquid-liquid interface of the working substance moves relative to the cavity, so that the working substance has a flow visualization effect. The working substance is disposed in the cavity of the liquid cooling component, and the visible light transmittance of at least the partial area of the liquid cooling component is greater than or equal to the threshold, so that the flow visualization effect of the working substance can be displayed through the area, that is, the liquid cooling module can achieve a visualization effect. In addition, in the flowing process of the working substance, the working substance may be used as a medium for heat transfer, so that the liquid cooling component can achieve a heat dissipation function.

With reference to a feasible implementation of the first aspect, the working substance further includes a demulsifier. The demulsifier is used to break an emulsion. When the second phase is dispersed in the first medium in a form of small droplet to form an emulsion (the liquid-liquid interface is broken), the demulsifier having a function of breaking the emulsion may cause small droplets to gather with each other, so that the liquid-liquid interface between the first medium and the second phase is restored.

With reference to an implementation of the first aspect, the first medium includes at least one of water and a liquid metal.

In this implementation, the first medium includes at least one of water (H₂O) and the liquid metal. The H₂O and the liquid metal have good heat dissipation performance, and the H₂O and the liquid metal may be used as the first medium to ensure that the working substance can achieve good heat dissipation performance, so that the liquid cooling module can achieve a good temperature control function.

With reference to an implementation of the first aspect, the working substance further includes a water-soluble dye, and solubility of the water-soluble dye in the first medium is greater than solubility of the water-soluble dye in the second phase.

In this implementation, the working substance includes the water-soluble dye. The solubility of the water-soluble dye in the first medium is greater than the solubility of the water-soluble dye in the second phase. The water-soluble dye may be introduced to increase color contrast between the first medium and the second phase, so that the liquid cooling module can have a significant flow visualization effect.

With reference to an implementation of the first aspect, in an environment of 25°C, a thermal conductivity of the first medium is greater than or equal to 0.1 W/m·k.

In this implementation, in the environment of 25°C, the thermal conductivity of the first medium is greater than or equal to 0.1 W/m·k. The first medium has a large thermal conductivity, so that the first medium of a unit length absorbs a large amount of heat per unit change in temperature, and the liquid cooling module can achieve a good temperature control function.

With reference to an implementation of the first aspect, in the environment of 25°C, a specific heat capacity of the first medium is greater than or equal to 1000 J/kg·°C.

In this implementation, in the environment of 25°C, the specific heat capacity of the first medium is greater than or equal to 1000 J/kg·°C. The first medium has a large specific heat capacity, and the first medium of a unit mass absorbs a large amount of heat per unit change in temperature, so that the liquid cooling module can achieve a good temperature control function.

With reference to an implementation of the first aspect, in the environment of 25°C, a viscosity of the first medium is less than or equal to 50 cp.

In this implementation, in the environment of 25°C, the viscosity of the first medium is less than or equal to 50 cp. The first medium has a low viscosity, so that resistance to the first medium in the flowing process is small, the first medium can transfer a large amount of heat per unit time, and the working substance can achieve a good temperature control function.

With reference to an implementation of the first aspect, a mass fraction of the first medium is greater than or equal to 80%.

In this implementation, the mass fraction of the first medium is greater than or equal to 80%, that is, the working substance includes a large amount of first medium. The first medium has good heat dissipation performance to ensure that the working substance can achieve good heat dissipation performance, so that the liquid cooling module can achieve a good temperature control function.

With reference to an implementation of the first aspect, the second phase includes at least one second medium.

In this implementation, the second phase includes at least one second medium, and each second medium may form a liquid-liquid interface with the first medium, so that the working substance presents a flow visualization effect.

With reference to an implementation of the first aspect, at least two second media are miscible with each other.

With reference to an implementation of the first aspect, a liquid-liquid interface exists between any two second media.

In this implementation, the liquid-liquid interface exists between any two second media, and correspondingly, the working substance has a large quantity of liquid-liquid interfaces, so that the working substance has a significant flow visualization effect.

With reference to an implementation of the first aspect, the apparatus further includes an organic dye, where solubility of the organic dye in the second medium is greater than solubility of the organic dye in the first medium.

In this implementation, the working substance may further include the organic dye. The solubility of the organic dye in the second medium is greater than the solubility of the organic dye in the first medium. The organic dye may be introduced to increase color contrast between the first medium and the second phase, so that the working substance can have a significant flow visualization effect.

With reference to an implementation of the first aspect, the working substance further includes a drag-reducing additive; and the drag-reducing additive is used to reduce flow resistance of the first medium.

In this implementation, the working substance may include the drag-reducing additive. The drag-reducing additive can reduce flow resistance of the first medium, so that the working substance transfers a large amount of heat per unit time, and the liquid cooling module can achieve a good temperature control function.

With reference to an implementation of the first aspect, the drag-reducing additive includes at least one of poly-α-olefin, poly(methyl methacrylate), polyacrylamide, polyethylene oxide, poly-α-octylene, poly-α-decene, and cationic polyacrylamide.

The drag-reducing additive can reduce flow resistance of the first medium, and increase a flow velocity of the working substance under same pump performance. The working substance transfers a large amount of heat per unit time, so that the liquid cooling module can achieve a good temperature control function.

With reference to an implementation of the first aspect, a relative molecular mass of the drag-reducing additive is greater than or equal to 2* 10⁵.

In this implementation, the relative molecular mass of the drag-reducing additive may be greater than or equal to 5* 10⁵. The drag-reducing additive has a large relative molecular mass, a long molecular chain, and high flexibility, and can greatly reduce flow resistance generated in a flowing process of the first medium and increase a flow velocity of the working substance under same pump performance, so that the first medium can transfer a large amount of heat per unit time, heat dissipation performance of the working substance is improved, and the liquid cooling module can be ensured to achieve a good temperature control function.

With reference to an implementation of the first aspect, the demulsifier includes at least one of sodium alkyl naphthalate sulfonate, sodium alkane sulfonate, naphthenate, polyoxyethylene-polyoxypropylene copolymer, organic alcohol, and organic ketone.

In this implementation, the demulsifier includes at least one of sodium alkyl naphthalate sulfonate, sodium alkane sulfonate, naphthenate, polyoxyethylene-polyoxypropylene copolymer, organic alcohol, and organic ketone. The demulsifier may break an emulsion formed by the second phase and the first medium, to restore the liquid-liquid interface between the first medium and the second phase, so that the working substance has a stable liquid-liquid interface, and the liquid cooling module can have a stable flow visualization effect.

With reference to an implementation of the first aspect, a molecular structural formula of the sodium alkyl naphthalate sulfonate includes: 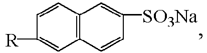 where R includes a lipophilic group.

In this implementation, the molecular structural formula of the sodium alkyl naphthalate sulfonate includes (SO₃Na⁻), so that a binding capability between the sodium alkyl naphthalate and the first medium is stronger than a binding capability between the second medium and the first medium. When the second medium is dispersed in the first medium in a form of small droplet to form an emulsion, the first medium is preferably bonded with SO₃Na⁻. In this case, a thickness of a hydrated layer on a surface of the small droplet is reduced, and small droplets tend to gather with each other to restore the liquid-liquid interface with the first medium.

In addition, the molecular structural formula of the sodium alkyl naphthalate sulfonate includes a naphthalene ring 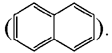 The naphthalene ring has high rigidity, to ensure that the demulsifier has high rigidity. When the second phase and the first medium are emulsified, the second phase is dispersed in the first medium in a form of small droplet. Because the demulsifier has high rigidity, the demulsifier may reach surfaces of small droplets quickly, so that the small droplets can get rid of a constraint of the first medium to gather with each other to form the second phase, that is, the demulsifier has high emulsion breaking efficiency, and the working substance can quickly restore the liquid-liquid interface.

With reference to an implementation of the first aspect, a molecular structural formula of the naphthenate includes: 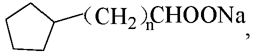 where n in 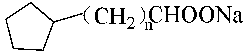 ranges from 3 to 12.

In this implementation, 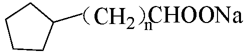 has carboxyl (-COO⁻), and a binding capability between -COO⁻ and water is stronger than a binding capability between the second medium and water, and therefore, 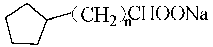 may be used as the demulsifier. In addition, a molecular structural formula of the naphthenate includes cycloalkyl 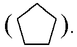 The cycloalkyl has high rigidity, so that the naphthenate may have high rigidity. During emulsification, the demulsifier can reach the surface of the small droplet quickly, to achieve an emulsification function, and ensure that an emulsified working substance can quickly restore the liquid-liquid interface.

With reference to an implementation of the first aspect, a molecular structural formula of the organic alcohol includes:
at least one of

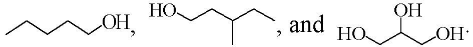

In this implementation, the molecular structural formula of the organic alcohol includes hydroxyl (-OH), and a binding capability between the hydroxyl and water is stronger than a binding capability between the second medium and water. Therefore, the organic alcohol may be used as the demulsifier. In addition, the molecular structural formula of the organic alcohol may include 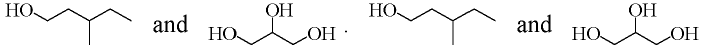 have symmetric molecular structures, so that the demulsifier has high rigidity to ensure that the demulsifier has high emulsion breaking efficiency, and ensure that the emulsified working substance can quickly restore the liquid-liquid interface.

With reference to an implementation of the first aspect, a molecular structural formula of the organic ketone includes at least one of

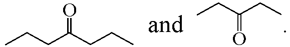

In this implementation, the molecular structural formula of the organic ketone includes: carbonyl (-C=O), where a binding capability between -C=O and water is stronger than a binding capability between the second medium and water. Therefore, the organic ketone may be used as the demulsifier. In addition, the molecular structural formula of the organic ketone may include 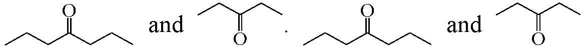 have symmetric molecular structures, so that the demulsifier has high rigidity to ensure that the demulsifier has high emulsion breaking efficiency, and ensure that the emulsified working substance can quickly restore the liquid-liquid interface.

With reference to an implementation of the first aspect, a hydrophilic lipophilic balance of the demulsifier ranges from 1 to 20.

In this implementation, the hydrophilic lipophilic balance of the demulsifier ranges from 1 to 20, so that the demulsifier may exist at the liquid-liquid interface between the first medium and the second phase, and the demulsifier may stabilize the liquid-liquid interface, to ensure that the liquid cooling module has a stable flow visualization effect.

With reference to an implementation of the first aspect, the liquid cooling component includes a flow channel layer and at least two coverage layers, where one coverage layer is disposed on one side of the flow channel layer, the other coverage layer is disposed on the other side of the flow channel layer, the cavity is enclosed by the coverage layers and the flow channel layer, and a visible light transmittance of at least one coverage layer is greater than or equal to the threshold.

With reference to an implementation of the first aspect, a difference between a melting temperature of the flow channel layer and a melting temperature of the coverage layer is less than or equal to 20°C.

In this implementation, the difference between the melting temperature of the coverage layer and the melting temperature of the flow channel layer is less than or equal to 20°C. A small difference between the melting temperature of the coverage layer and the melting temperature of the coverage layer helps implement a cavity of an integrated structure by sealing the coverage layer and the flow channel layer through hot pressing, and ensures that the cavity has a good sealing effect.

With reference to an implementation of the first aspect, a difference between a coefficient of thermal expansion of the flow channel layer and a coefficient of thermal expansion of the coverage layer is less than or equal to 10*10⁻⁶/°C.

In this implementation, the difference between the coefficient of thermal expansion of the flow channel layer and coefficient of thermal expansion of the coverage layer is less than or equal to ≤ 10* 10⁻⁶/°C. The difference between the coefficient of thermal expansion of the flow channel layer and the coefficient of thermal expansion of the coverage layer is small, so that warpage between the flow channel layer and the coverage layer in a sealing and welding process can be reduced to a specific extent, and the cavity enclosed by the coverage layers and the flow channel layer is ensured to have a good sealing effect.

With reference to an implementation of the first aspect, a thickness of the coverage layer is less than or equal to 2 mm.

In this implementation, the thickness of the coverage layer is less than or equal to less than 2 mm, so that a lightweight liquid cooling module can be implemented. In another aspect, the coverage layer has a small blocking effect on the working substance, so that a liquid cooling module with a significant flow visualization effect can be implemented.

With reference to an implementation of the first aspect, a transparent material includes at least one of inorganic glass, polyethylene terephthalate, polyethylene naphthalate, polypropylene, cyclo-olefin copolymer, polytetramethylpentene, polyimide, poly(methyl methacrylate), polyphenylene sulfide, polyether ether ketone, styrene-acrylonitrile copolymer, acrylonitrile-butadiene-styrene copolymer, and butadiene-styrene copolymer.

In this implementation, at least a partial area of the liquid cooling component is made of the transparent material, so that the coverage layer has a large visible light transmittance, and the liquid cooling module may be ensured to achieve a significant flow visualization effect.

With reference to an implementation of the first aspect, a molecular structural formula of the transparent material includes:
at least one of 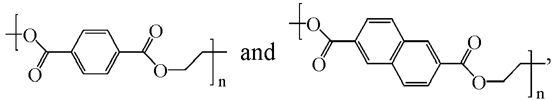 where
n in 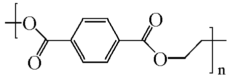 ranges from 100 to 200; and n in 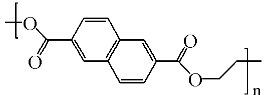 ranges from 100 to 200.

In this implementation, the molecular structural formula of the transparent material includes an ether bond (-O-), and the ether bond may break a conjugate structure of a benzene ring in the molecular structural formula, so that the transparent material has a large visible light transmittance, and the liquid cooling module can achieve a significant flow visualization effect.

With reference to an implementation of the first aspect, a molecular structural formula of the transparent material includes:
at least one of 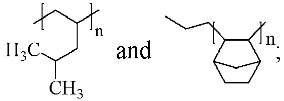 and
n in 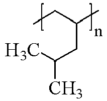 ranges from 240 to 340; and n in 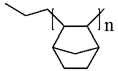 ranges from 200 to 300.

In this implementation, the molecular structural formula of the transparent material includes at least one of 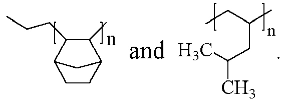 The transparent material has a large visible light transmittance, so that the liquid cooling module can achieve a significant flow visualization effect.

With reference to an implementation of the first aspect, the apparatus further includes an anti-evaporation layer, where the anti-evaporation layer is disposed on a surface of the coverage layer, a visible light transmittance of the anti-evaporation layer is greater than or equal to a threshold, and a density of the anti-evaporation layer is greater than a density of the coverage layer.

In this implementation, the anti-evaporation layer is disposed on the surface of the coverage layer. The density of the anti-evaporation layer is greater than the density of the coverage layer. The anti-evaporation layer can reduce an evaporation loss of the working substance, to ensure long-term reliability of the liquid cooling module. In addition, the visible light transmittance of the anti-evaporation layer is greater than or equal to the threshold, so that a flow visualization effect of the liquid cooling module is ensured.

A second aspect of this application discloses an electronic device, including a housing and the liquid cooling module disclosed in the first aspect. The liquid cooling module is embedded in the housing, a visible light transmittance of at least a partial area of the housing is greater than or equal to a threshold, and an area in which a visible light transmittance of the housing is greater than or equal to the threshold at least partially overlaps an area in which a visible light transmittance of the liquid cooling component is greater than or equal to the threshold.

For an effect that can be achieved by any feasible implementation of the second aspect, refer to the effect that can be achieved by any feasible implementation of the first aspect. Details are not described herein again.

A third aspect of this application discloses an accessory. The accessory is used in an electronic device, and includes an accessory body and the liquid cooling module disclosed in the first aspect. The liquid cooling module is embedded in the accessory body; and an area in which a visible light transmittance of the accessory body is greater than or equal to a threshold at least partially overlaps an area in which a visible light transmittance of the liquid cooling component is greater than or equal to the threshold.

For an effect that can be achieved by any feasible implementation of the third aspect, refer to the effect that can be achieved by any feasible implementation of the first aspect. Details are not described herein again.

### BRIEF DESCRIPTION OF DRAWINGS

FIG. 1 is a diagram of an electronic device;
FIG. 2 is an exploded view of a battery;
FIG. 3 is a diagram of a working substance disclosed in a feasible embodiment (the working substance is filled in a cavity);
FIG. 4 is a diagram of an emulsified working substance (the working substance is filled in a cavity);
FIG. 5 is a diagram of a wall-hanging working substance (the working substance is filled in a cavity);
FIG. 6 is a diagram of a liquid cooling module disclosed in a feasible embodiment;
FIG. 7 shows a curve of a relationship between a flow rate and impedance that are of a liquid cooling module;
FIG. 8 is a diagram of a mobile phone disclosed in a feasible embodiment;
FIG. 9 is a diagram of a tablet computer disclosed in a feasible embodiment;
FIG. 10 is a diagram of a notebook computer disclosed in a feasible embodiment;
FIG. 11 is a diagram of a vehicle-mounted device disclosed in a feasible embodiment;
FIG. 12 is a sectional view of a flow display area disclosed in a feasible embodiment;
FIG. 13 is a diagram of a protective case disclosed in a feasible embodiment;
FIG. 14 is a diagram of assembly of a wearable device and a wrist strap disclosed in a feasible embodiment;
FIG. 15 is a diagram of assembly of a tablet computer and a protective case disclosed in a feasible embodiment; and
FIG. 16 is a diagram of assembly of a mobile phone and a connector disclosed in a feasible embodiment.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, position terms such as "top" and "bottom" are defined relative to positions of structures in the accompanying drawings. It should be understood that these position terms are relative concepts used for relative description and clarification, and may correspondingly change according to changes in the positions of the structures.

Concepts in embodiments of this application are first described.

Surface tension (surface tension): Liquid such as water generates a force that reduces a surface as much as possible. A wall hanging phenomenon of the liquid is related to surface tension of the liquid. Greater surface tension of the liquid indicates a more obvious wall hanging phenomenon of the liquid.

Emulsification is an effect in which tiny droplets of liquid are evenly dispersed in another liquid that is immiscible with the liquid.

A melting temperature (melting point) is a temperature at which melting occurs, and may also be referred to as a melting point.

A coefficient of thermal expansion (coefficient of thermal expansion, CET) indicates how an object expands or shrinks with a change in temperature. A change ability of the coefficient of thermal expansion is expressed by a length change caused by a per unit change in temperature under constant pressure (p is constant), that is, a unit of the coefficient of thermal expansion is 1/degree (°C).

Visible light (visible light) may be understood as a light wave with a wavelength of 380 nm to 760 nm.

A visible light transmittance (transmittance) is a ratio of radiant energy projected to and transmitted through an object to total radiant energy projected to the object.

A hydrophilic group (hydrophilic group) may also be referred to as a polar group, and has an atomic group that is water-soluble or easily has an affinity for water.

A lipophilic group (lipophilic group, or oelophilic group) may also be referred to as a non-polar group, and is a group that has no affinity for water, is insoluble in water or has extremely low solubility.

A hydrophilic lipophilic balance (hydrophilic lipophilic balance, HLB) may be understood as a comprehensive affinity of a hydrophilic group and a lipophilic group in a surfactant (auxiliary) molecule to oil or water.

A mass fraction of a medium may be understood as a mass ratio of the medium to the working substance.

An electronic device in embodiments of this application may include but is not limited to electronic products such as a mobile phone, a tablet computer, a notebook computer, and a wearable device.

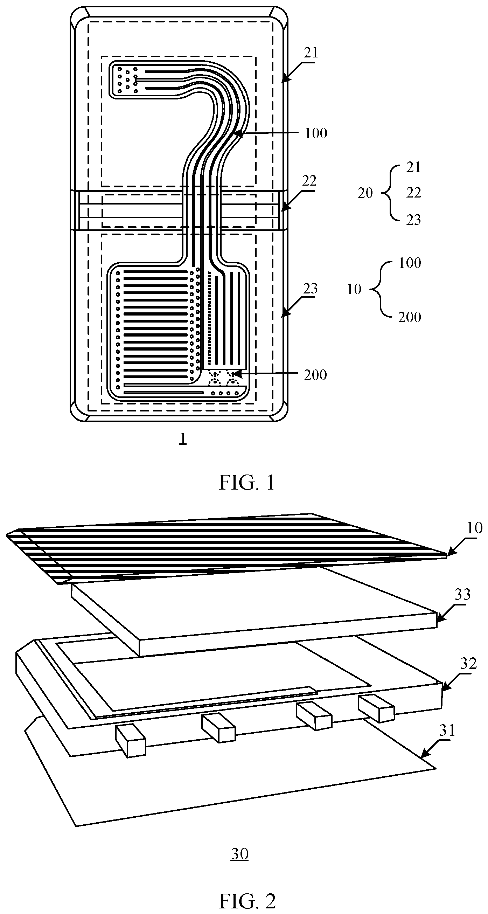

FIG. 1 is a diagram of an electronic device (a mobile phone). It can be learned that an electronic device 1 includes a housing 20 and an electronic functional component (not shown in the figure).

A cavity configured to accommodate the electronic functional component is enclosed by the housing, and the housing encloses the electronic functional component to protect the electronic functional component.

In embodiments of this application, the electronic device may include a foldable device or a bar-type device. The following describes the housing of the electronic device by using an example in which the electronic device may be a foldable device.

Refer to FIG. 1. The housing 20 of the electronic device may include a first non-folding part 21 and a second non-folding part 22. The first non-folding part 21 and the second non-folding part 22 are connected through a folding part 23. The second non-folding part 22 can be folded toward the first non-folding part 21 through the folding part 23. The second non-folding part 22 is unfolded through the folding part 23 and the first non-folding part 21.

The electronic functional component in the electronic device 1 includes but is not limited to a processor, an internal memory, a charging management module, a power management module, a battery, an antenna, a communication module, a camera, an audio module, a loudspeaker, a receiver, a microphone, a sensor module, a motor, an indicator, and the like. The electronic device 1 may have more or fewer electronic functional components than those described above. Various electronic functional components may be implemented in hardware, software, or a combination of hardware and software including one or more signal processing and/or application-specific integrated circuits.

The electronic functional component releases heat in a working state. When a temperature inside the electronic device 1 is excessively high, working efficiency of the electronic functional component and a service life of the electronic device 1 are affected. Therefore, a liquid cooling module 10 needs to be disposed, to control temperature rise of the electronic functional component.

Based on the foregoing considerations, in some feasible implementations, the liquid cooling module 10 is embedded in the housing 20, to control a temperature of the electronic functional component disposed in a limited area of the housing.

For example, still refer to FIG. 1. It can be learned that the liquid cooling module 10 is located in the housing 20 (the liquid cooling module 10 is actually invisible in the electronic device 1, and is shown in a visible diagram for ease of understanding). The liquid cooling module 10 embedded in the housing may control a temperature of the electronic functional component.

The following describes the solutions disclosed in this application.

The electronic device in embodiments of this application may include but is not limited to electronic products such as a mobile phone, a tablet computer, a notebook computer, a wearable device, and a vehicle-mounted device.

Refer to FIG. 1 and FIG. 1. It can be learned that the electronic device includes the housing 20 and the electronic functional component (not shown in the figure) located in the housing 20. In embodiments of this application, the electronic device may be a foldable device or a bar-type device.

For example, refer to FIG. 1. A foldable mobile phone is used as an example to further describe the housing. The housing 20 may include the cavity configured to accommodate the electronic functional component (not shown in the figure). The housing 20 of the foldable mobile phone may include a first non-folding part 21 and a second non-folding part 22. The first non-folding part 21 and the second non-folding part 22 are connected through a folding part 23. The second non-folding part 22 can be folded toward the first non-folding part 21 through the folding part 23. The second non-folding part 22 is unfolded through the folding part 23 and the first non-folding part 21.

The electronic functional component in the electronic device 1 includes but is not limited to a processor, an internal memory, a charging management module, a power management module, a battery, an antenna, a communication module, a camera, an audio module, a loudspeaker, a receiver, a microphone, a sensor module, a motor, an indicator, and the like. The electronic device 1 may have more or fewer electronic functional components than those described above. Various electronic functional components may be implemented in hardware, software, or a combination of hardware and software including one or more signal processing and/or application-specific integrated circuits.

The electronic functional component releases heat in a working state. When a temperature inside the electronic device 1 is excessively high, working efficiency of the electronic functional component and a service life of the electronic device 1 are affected. Therefore, the liquid cooling module 10 needs to be disposed, to control temperature rise of the electronic functional component.

Based on the foregoing considerations, in some feasible implementations, the liquid cooling module 10 is located between the housing 20 and the electronic functional component, to control a temperature of the electronic functional component. For example, still refer to FIG. 1. It can be learned that the liquid cooling module 10 is located on a side that is of the housing 20 and that is close to the electronic functional component. The liquid cooling module 10 may control the temperature of the electronic functional component.

In some feasible implementations, the liquid cooling module 10 may be used as a part of electronic functional component package, to control a temperature of the electronic functional component. For example, FIG. 2 is an exploded view of a battery. A battery 30 may include a protective plate 31, a tray 32, a cell 33, and the liquid cooling module 10 that are sequentially stacked. As a part of the battery, the liquid cooling module 10 may control a temperature of the battery.

The following describes a temperature control function of the liquid cooling module 10.

Still refer to FIG. 1. The liquid cooling module 10 may include a liquid cooling component 100, a pump 200, and a working substance (not shown in the figure). The working substance is filled in a cavity of the liquid cooling component 100. The pump 200 communicates with the cavity of the liquid cooling component 100. The pump 200 may be used as a power source for the working substance in the liquid cooling component 100, to provide flowing power for the working substance.

In a flowing process, the working substance may be used as a carrier for heat transfer, to take heat away from the electronic functional component, so as to control a temperature of the electronic functional component.

In this embodiment of this application, the cavity of the liquid cooling component 100 provides a flowing track/place for flowing of the working substance. Therefore, in embodiments of this application, the cavity of the liquid cooling component 100 may be referred to as a flow channel.

A type of the pump 200 is not specifically limited in embodiments of this application. In some feasible implementations, the pump 200 may be a micro piezoelectric liquid pump. An amplitude of the micro piezoelectric liquid pump is less than or equal to 50 um. The micro piezoelectric liquid pump features ultra-thinness, a small size, a simple structure, high pressure, a small flow rate, no electromagnetic interference, and low noise, can achieve precise fluid transmission and control, and is especially suitable for electronic devices such as a mobile phone, a watch, and an accessory.

In some related technologies, flowing preparation of the working substance presents a visualization effect, so that a flow display area with a sense of science and technology can be implemented. The flow display area may be used to identify a component or beautify a housing, to improve user experience of using the electronic device.

Currently, an implementation of flow visualization of the working substance in the liquid cooling module 10 is as follows: The transparent liquid cooling component 100 is configured with a flow-visualization working substance, that is, light transmission processing is performed in an area of the housing 20 in which a flow visualization effect needs to be displayed, so that a visualization effect of the working substance disposed inside the housing is displayed, and a flow visualization area with a sense of science and technology is formed in the area in which light transmission processing is performed.

A working substance whose flow status is visible and that is disclosed in the related technology includes water and a dye. The dye may color the working substance, so that a flowing process of the working substance may present a flow visualization effect.

Therefore, a colored working substance may present the flow visualization effect in a liquid cooling module 10 with a large size. A size of the liquid cooling module 10 used in the electronic device is small (a cavity size of the liquid cooling module 10 is usually on the microliter-scale), and the flow visualization effect of the working substance disclosed in the related technology in the electronic device is poor.

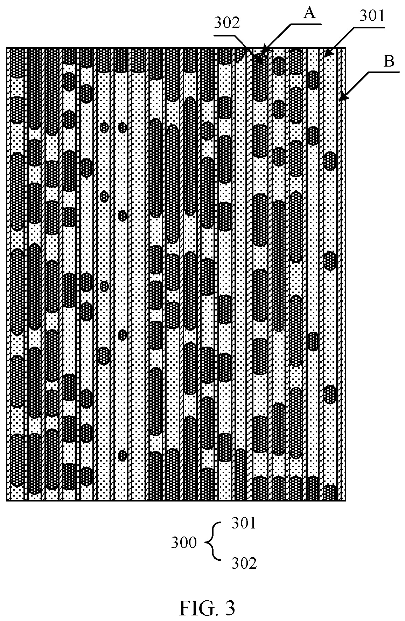

To resolve a technical problem in a related technology, refer to FIG. 3. According to a first aspect, an embodiment of this application discloses a working substance. A working substance 300 includes a first medium 301 and a second phase 302. A liquid-liquid interface A exists between the first medium 301 and the second phase 302. In a process in which the working substance moves, the liquid-liquid interface A moves relative to a cavity B configured to accommodate the working substance, so that the working substance 300 has a flow visualization effect.

The following further describes components of the working substance disclosed in this embodiment of this application.

The working substance disclosed in this embodiment of this application includes the first medium. The first medium has good heat dissipation performance, and ensures that the working substance can achieve a good temperature control function. In addition, the first medium needs to form a liquid-liquid interface with the second phase, to ensure that the working substance can achieve a flow visualization function.

In a feasible implementation, a mass fraction of the first medium in the working substance is greater than or equal to 80%. For example, the mass fraction of the first medium in the working substance may be 85%, 90%, 95%, or the like.

In this implementation, the mass fraction of the first medium in the working substance is greater than or equal to 80%, that is, the working substance includes a large amount of first medium (the first medium has good heat dissipation performance), to ensure that the working substance can achieve good heat dissipation performance. The working substance absorbs a large amount of heat per unit change in temperature, and the working substance can achieve a good temperature control function.

A type of a medium included in the first medium is not specifically limited in embodiments of this application. Any medium that has good heat dissipation performance and that can form a liquid-liquid interface with the second phase may be used as the first medium in embodiments of this application.

For example, in some feasible implementations, the first medium may include water (H₂O), a liquid metal, and the like.

In embodiments of this application, the H₂O and the liquid metal have good heat dissipation performance. The H₂O and liquid metal are used as the first medium, so that the working substance can achieve good heat dissipation performance, and the working substance can be ensured to achieve a good temperature control function.

In embodiments of this application, the working substance may further include a water-soluble salt. A solution formed by the water-soluble salt and water (the first medium) may be referred to as a salt solution.

The salt solution may include anions and cations. Both anion and cation have strong hydrophilic properties. In this way, the anion may form a hydrated anion with H₂O, and the cation may form a hydrated cation with H₂O. That is, H₂O tends to bind with the cation/anion.

When the second phase is dispersed in H₂O in a form of small droplet to form an emulsion, the H₂O is preferably bound with the cation and the anion. In this way, a thickness of a hydrated layer on a surface of the small droplet is reduced, and small droplets tend to gather with each other to form the second phase, so as to restore the liquid-liquid interface between the first medium and the second phase. Therefore, in this implementation, the working substance has a stable liquid-liquid interface, and the liquid cooling module using the working substance may have a stable flow visualization effect.

A color of the salt solution is not specifically limited in embodiments of this application. In a feasible implementation, the salt solution may be a colorless solution.

In this embodiment of this application, the colorless solution may include H₂O (solvent) and a colorless salt (solute). The colorless salt may be understood as a salt whose aqueous solution is colorless. For example, the colorless salt may include but is not limited to sodium chloride (NaCl), magnesium chloride (MgCl₂), calcium chloride (CaCl₂), aluminum nitrate (Al(NO₃)₄), and the like.

To further improve the flow visualization effect of the working substance, in a feasible implementation, the salt solution may include a colored solution.

In this embodiment of this application, the colored solution may include: H₂O and a colored salt. The colored salt may be understood as a salt whose aqueous solution is colored. For example, the colored salt may include but is not limited to: copper sulfate (CuSO₄), copper chloride (CuCl₂), copper nitrate (Cu(NO₃)₂), ferrous sulfate (FeSO₄), ferrous chloride (FeCl₂), ferrous nitrate (Fe(NO₃)₂), ferric sulfate (Fe₂(SO₄)₃), ferric chloride (FeCl₃), ferric nitrate (Fe(NO₃)₃), potassium permanganate (KMnO₄), cobalt chloride (CoCl₂ · n(H₂O)), cobalt sulfate (CoSO₄), cobalt nitrate (Co(NO₃)₂), nickel chloride (NiCl₂), nickel sulfate (NiSO₄), nickel nitrate (Ni(NO₃)₂), and the like.

The colored salt may change color of the first medium. Therefore, in embodiments of this application, the colored salt may also be referred to as a water-soluble dye or an inorganic dye.

In this implementation, the working substance includes the water-soluble dye. Solubility of the water-soluble dye in the first medium is greater than solubility of the water-soluble dye in the second phase. The water-soluble dye may color the first medium. The water-soluble dye may be introduced to make the first medium have a large color contrast with the second phase, so that the working substance can have a significant flow visualization effect.

The following further describes performance of the first medium.

Heat dissipation performance may be understood as heat absorbed or released by the medium per unit change in temperature. Better heat dissipation performance of the medium indicates more heat absorbed or released by the medium per unit change in temperature, and a more significant temperature control effect of the medium.

A thermal conductivity (thermal conductivity) may be understood as heat transferred when a temperature difference between surfaces on two sides of the medium (area: 1 m², and thickness: 1 m) is 1°C (or K) under a stable heat transfer condition (for example, constant pressure P and a constant temperature T). A higher thermal conductivity of the medium indicates more heat absorbed by the first medium of a unit length per unit change in temperature, and a more significant temperature control effect of the working substance.

In a feasible implementation, in an environment of 25°C, a thermal conductivity of the first medium is greater than or equal to 0.1 W/m·K. For example, in the environment of 25°C, the thermal conductivity of the first medium may be 0.1 W/m·K, 0.2 W/m·K, 0.3 W/m·K, or the like.

It should be noted that the thermal conductivity of the first medium is not a constant value. The thermal conductivity of the first medium is affected by a temperature. Specifically, a temperature increase intensifies molecular thermal motion of the first medium, so that more heat can be transferred by heating the medium. In other words, the thermal conductivity of the first medium increases accordingly when the temperature increases. Unless otherwise specified, the thermal conductivity in this embodiment of this application may be understood as the thermal conductivity of the first medium at 25°C.

In this implementation, in the environment of 25°C, the thermal conductivity of the first medium is greater than or equal to 0.1 W/m·k. The first medium has a large thermal conductivity, so that the first medium of a unit length absorbs a large amount of heat per unit change in temperature, and the working substance can achieve a good temperature control function.

A specific heat capacity (specific heat capacity) may be understood as a heat capacity of the first medium of a unit mass. A higher specific heat capacity of the first medium indicates more heat absorbed by the first medium of a unit mass per unit change in temperature, and a more significant temperature control function of the working substance.

It should be noted that the specific heat capacity of the first medium is affected by a temperature. Unless otherwise specified, the specific heat capacity in this embodiment of this application may be understood as a specific heat capacity of the first medium at 25°C.

To ensure a temperature control function of the working substance, in a feasible implementation, in the environment of 25°C, the specific heat capacity of the first medium is greater than or equal to 1000 J/kg·°C. For example, in the environment of 25°C, the specific heat capacity of the first medium may be 1000 J/kg·°C, 1500 J/kg·°C, 1500 J/kg·°C, or the like.

In this implementation, in the environment of 25°C, the specific heat capacity of the first medium is greater than or equal to 1000 J/kg·°C. The first medium has a high specific heat capacity, so that the first medium of a unit mass absorbs a large amount of heat per unit change in temperature, and the working substance can achieve a good temperature control function.

A viscosity (viscosity) may be understood as resistance of the first medium to flowing. Specifically, in this embodiment of this application, a lower viscosity of the first medium indicates smaller resistance to the first medium in a flowing process, more heat transferred by the first medium per unit time, and a more significant temperature control function of the working substance.

It should be noted that the viscosity of the first medium is affected by a temperature. Unless otherwise specified, the viscosity in this embodiment of this application may be understood as a viscosity of the first medium at 25°C.

In a feasible implementation, in the environment of 25°C, the viscosity of the first medium may be less than or equal to 50 cp. For example, in the environment of 25°C, the viscosity of the first medium may be 50 cp, 40 cp, 30 cp, 20 cp, 10 cp, or the like.

In this implementation, in the environment of 25°C, the viscosity of the first medium is less than or equal to 50 cp. The first medium has a low viscosity, so that resistance to the first medium in the flowing process is small, the first medium can transfer a large amount of heat per unit time, and the working substance can achieve a good temperature control function.

In this way, a description of the first medium is completed.

The working substance disclosed in this embodiment of this application further includes a second phase.

In this embodiment of this application, the second phase is configured to form a liquid-liquid interface with the first medium, so that the working substance can achieve a flow visualization effect. In this embodiment of this application, a medium included in the second phase may be referred to as a second medium.

The second medium is not specifically limited in embodiments of this application. Any medium that can form a liquid-liquid interface with the first medium may be used as the second medium in embodiments of this application. For example, the second medium may include but is not limited to a hydrocarbon (hydrocarbon), a heterocyclic compound (heterocyclic compound), a fluorinated liquid (fluorinated liquid), light oil, and the like.

A quantity of second media included in the second phase is not specifically limited in embodiments of this application. For example, the quantity of second media included in the second phase may be 1, 2, 3, or the like.

A dissolution status between second media is not specifically limited in embodiments of this application.

In some feasible implementations, at least two second media are miscible with each other.

For example, the second phase may include the hydrocarbon and the heterocyclic compound. The hydrocarbon and the heterocyclic compound may be miscible with each other to form a homogeneous phase (the second phase).

For example, the second phase may include the hydrocarbon, the heterocyclic compound, and the light oil. The hydrocarbon and the heterocyclic compound may be miscible with each other to form mixed organic liquid. A liquid-liquid interface is formed between the light oil and the mixed organic liquid (that are immiscible with each other).

In some feasible implementations, a liquid-liquid interface exists between any two second media.

For example, the second phase may include the fluorinated liquid and the light oil. The fluorinated liquid and the light oil may form a liquid-liquid interface.

It should be noted that, in this embodiment of this application, only several dissolution statuses between second media are described as examples, and the foregoing examples do not constitute a specific limitation.

In some feasible implementations, a molecular structural formula of the hydrocarbon may include:
CH₃- (CH₂)ₙ-CH₃ , 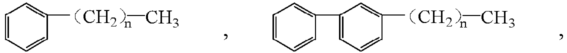 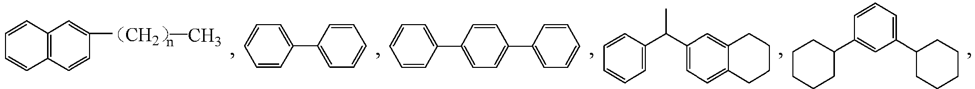 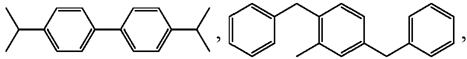 and the like.

It is considered that stability of the liquid-liquid interface is related to solubility of the second medium in the first medium. Specifically, a greater relative molecular mass of the second medium indicates lower solubility of the hydrocarbon in the first medium, a more stable liquid-liquid interface between the second medium and the first medium, and a more stable flow visualization effect of the working substance.

To obtain a working substance with a stable flow visualization effect, in a feasible implementation, n in CH₃- (CH₂)ₙ-CH₃ may be greater than or equal to 5.

In this implementation, n in CH₃- (CH₂)ₙ-CH₃ is greater than or equal to 5, solubility of the hydrocarbon in the first medium is small, and the hydrocarbon and the first medium may form a stable liquid-liquid interface, to ensure that the working substance can achieve a stable flow visualization effect.

It is considered that stability of the liquid-liquid interface is related to a boiling point of the second medium. Specifically, a greater relative molecular mass of the second medium indicates a higher boiling point of the second medium, better thermal stability of the second medium, a more stable liquid-liquid interface between the second medium and the first medium, and a more stable flow visualization effect of the working substance.

To obtain a working substance with a stable flow visualization effect, in a feasible implementation, n in CH₃- (CH₂)ₙ-CH₃ may be greater than or equal to 5.

In this implementation, n in CH₃- (CH₂)ₙ-CH₃ is greater than or equal to 5, a boiling point of the hydrocarbon is high, and the hydrocarbon and the first medium may form a stable liquid-liquid interface, to ensure that the working substance can have a stable flow visualization effect.

It is considered that heat dissipation performance of the second medium is related to a viscosity of the second medium. Specifically, a smaller relative molecular mass of the second medium indicates a lower viscosity of the second medium, and better heat dissipation performance of the second medium.

To further improve a temperature control function in the working substance, in a feasible implementation, n in CH₃- (CH₂)ₙ-CH₃ may be less than or equal to 11.

In this implementation, n in CH₃- (CH₂)ₙ-CH₃ is less than or equal to 11, the hydrocarbon has a low viscosity, resistance to the working substance including the hydrocarbon is small in a flowing process, the working substance transfers a large amount of heat per unit time, and the working substance can achieve a good temperature control function.

To balance the stable flow visualization effect of the working substance and a good temperature control function, in a feasible implementation, n in CH₃- (CH₂)ₙ-CH₃ may range from 5 to 11.

Similarly, in a feasible implementation, n in 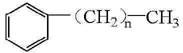 may be greater than or equal to 5. In a feasible implementation, n in 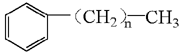 may be less than or equal to 11. In a feasible implementation, n in 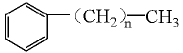 may range from 5 to 11.

Similarly, in a feasible implementation, n in 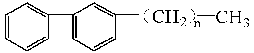 may be greater than or equal to 0. In a feasible implementation, n in 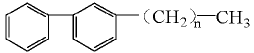 may be less than or equal to 5. In a feasible implementation, n in 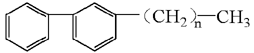 may range from 0 to 5.

Similarly, in a feasible implementation, n in 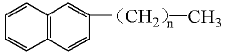 may be greater than or equal to 0. In a feasible implementation, n in 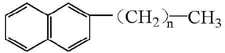 may be less than or equal to 5. In a feasible implementation, n in 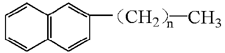 may range from 0 to 5, to balance the stable flow visual effect of the working substance and the good temperature control function.

In some feasible implementations, a molecular structural formula of the heterocyclic compound may include: 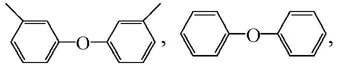 and the like.

In this implementation, the molecular structural formula of the heterocyclic compound (the second medium) includes a benzene ring 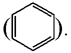 The benzene ring has high rigidity, so that the heterocyclic compound has high rigidity. When the heterocyclic compound and the first medium are emulsified, because the heterocyclic compound has high rigidity, under an action of a demulsifier, the heterocyclic compound can quickly get rid of a constraint of the first medium to form the second phase, so that the working substance restores the liquid-liquid interface, and implements a flow visualization effect.

In some feasible embodiments, the working substance may further include an organic dye. Solubility of the organic dye in the second medium is greater than the solubility of the organic dye in the first medium. The organic dye may be introduced to increase color contrast between the first medium and the second phase, so that the working substance can have a significant flow visualization effect.

In this way, the description of the second phase is completed.

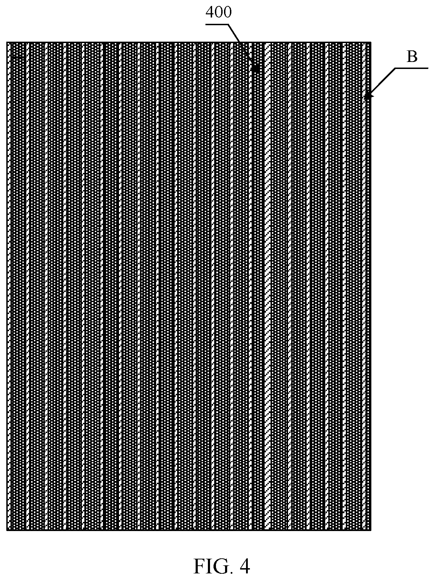

It should be noted that, when the working substance is in a static state, a liquid-liquid interface exists between the first medium and the second medium. When the working substance is in a flow status, the first medium and the second medium may be emulsified, that is, the second medium is dispersed in the first medium in a form of small droplet. Specifically, refer to FIG. 4. It can be learned that after the first medium and the second medium are emulsified, the second medium is dispersed in the second medium in a form of small droplet to form an emulsion 400, and the liquid-liquid interface between the first medium and the second medium is broken. In this case, the working substance loses a flow visualization function.

To obtain a working substance with a stable flow visualization function, in a feasible implementation, the working substance may further include a demulsifier. The demulsifier may break the emulsion, to restore the liquid-liquid interface between the first medium and the second phase, so that the working substance has a stable liquid-liquid interface, and the working substance can have a stable flow visualization effect.

The demulsifier is not specifically limited in embodiments of this application. Any auxiliary that can break the emulsion formed by the second phase and the first medium may be used as the demulsifier in embodiments of this application.

For example, the demulsifier may include sodium alkyl naphthalate sulfonate, sodium alkane sulfonate, naphthenate, polyoxyethylene-polyoxypropylene copolymer, organic alcohol, organic ketone, and the like.

In some feasible implementations, a hydrophilic lipophilic balance of the demulsifier ranges from 1 to 20, so that the demulsifier may exist at the liquid-liquid interface between the first medium and the second phase to stabilize the liquid-liquid interface, so as to ensure that the working substance has a stable flow visualization effect.

In a feasible implementation, a molecular structural formula of sodium alkyl naphthalate sulfonate includes: 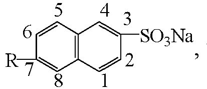 where R is a lipophilic group.

In this embodiment of this application, the lipophilic group may include cycloalkyl, alkoxy, alkyl, and the like.

It should be noted that, 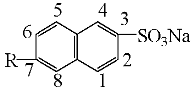 only shows an example of substituent locations of R and a sulfonyl hydroxide group (SO₃Na⁻) in the sodium alkyl naphthalate sulfonate, and the foregoing substituent location does not constitute a limitation. For example, in some feasible implementations, SO₃Na⁻ may be connected to C1, C2, and C4 on a naphthalene ring 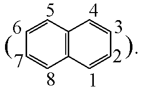 For another example, in some feasible implementations, R may be connected to C5, C6, and C8 on a naphthalene ring.

In this implementation, the molecular structural formula of the sodium alkyl naphthalate sulfonate includes (SO₃Na⁻), so that a binding capability between the sodium alkyl naphthalate and the first medium is stronger than a binding capability between the second medium and the first medium. When the second medium is dispersed in the first medium in a form of small droplet to form an emulsion, the first medium is preferably bonded with SO₃Na⁻. In this way, a thickness of a hydrated layer on a surface of the small droplet is reduced, and small droplets tend to gather with each other to form the second phase, so as to restore the liquid-liquid interface between the first medium and the second phase.

In addition, the molecular structural formula of the sodium alkyl naphthalate sulfonate includes a naphthalene ring. The naphthalene ring has high rigidity, to ensure that the demulsifier has high rigidity. When the second phase and the first medium are emulsified, the second phase is dispersed in the first medium in a form of small droplet. Because the demulsifier has high rigidity, the demulsifier may reach surfaces of small droplets quickly, so that the small droplets can get rid of a constraint of the first medium to gather with each other to form the second phase, that is, the demulsifier has high emulsion breaking efficiency, and the working substance can quickly restore the liquid-liquid interface.

It is considered that demulsification efficiency of the demulsifier is related to the rigidity of the demulsifier. Specifically, a large quantity of carbon atoms in a main chain of the demulsifier indicates a longer molecular chain of the demulsifier, weaker rigidity of the demulsifier, and lower demulsification efficiency of the demulsifier.

To ensure the demulsification efficiency of the sodium alkyl naphthalate sulfonate, in a feasible implementation, a quantity of carbon atoms in the main chain of R in 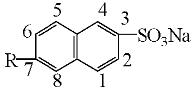 is less than or equal to 8.

It is considered that stability of a flow visualization effect of a cold working substance is related to a boiling point of the demulsifier. Specifically, a greater relative molecular mass of the demulsifier indicates a higher boiling point of the demulsifier, better stability of the demulsifier, a more stable liquid-liquid interface between the second phase and the first medium, and a more stable flow visualization effect of the working substance.

To obtain a working substance with a stable flow visualization effect, in a feasible implementation, a quantity of carbon atoms in a main chain of R in 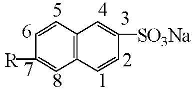 may be greater than or equal to 1.

In order to balance the demulsification efficiency and the stable visualization effect, in a feasible implementation, a quantity of carbon atoms in a main chain of R in 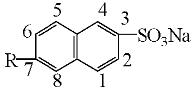 ranges from 1 to 8.

In a feasible implementation, a molecular structural formula of naphthenate includes:

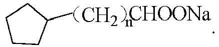

In this implementation, 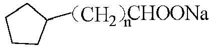 has (-COO⁻), and a binding capability between -COO⁻ and water is stronger than a binding capability between the second medium and water, and therefore, 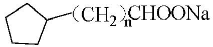 may be used as the demulsifier in this embodiment of this application.

A molecular structural formula of the naphthenate 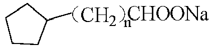 includes cycloalkyl 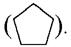 The cycloalkyl has high rigidity, so that the demulsifier can have high rigidity, and the demulsifier can reach a surface of a small droplet quickly, to achieve a demulsification function, that is, the demulsifier has high demulsification efficiency, and the working substance can quickly restore the liquid-liquid interface.

A relationship between the stability of the flow visualization effect of the cold working substance and the boiling point of the demulsifier is considered. In a feasible implementation, n in 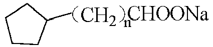 may be greater than or equal to 3, to ensure that 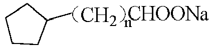 has a high boiling point, and further ensure that the working substance has a stable liquid-liquid interface.

A relationship between the demulsification efficiency of the demulsifier and the rigidity of the demulsifier is considered. In a feasible implementation, n in 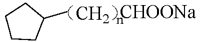 may be less than or equal to 12, to ensure that 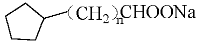 has high rigidity, and further ensure that the working substance has a stable liquid-liquid interface.

In a feasible implementation, n in 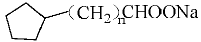 may range from 3 to 12.

In some feasible implementations, a molecular structural formula of the organic alcohol includes at least one of

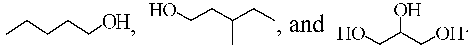

In this implementation, the molecular structural formula of the organic alcohol includes hydroxyl (-OH), and a binding capability between the hydroxyl and water is stronger than a binding capability between the second medium and water. Therefore, the organic alcohol may be used as a demulsifier in this embodiment of this application.

In this implementation, the molecular structural formula of the organic alcohol may include 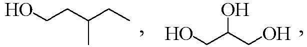 and the like. 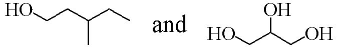 have symmetric molecular structures, so that the organic alcohol has high rigidity, to ensure that the demulsifier has high demulsification efficiency.

In this implementation, a molecular structural formula of the organic ketone includes: -C=O, where a binding capability between -C=O and water is stronger than a binding capability between the second medium and water. Therefore, the organic ketone may be used as a demulsifier in this embodiment of this application.

In some feasible implementations, a molecular structural formula of the organic ketone includes 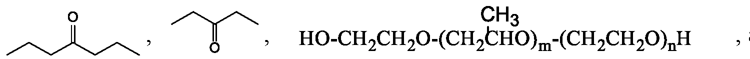 and the like.

In this implementation, the molecular structural formula of the organic ketone includes 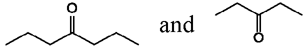 that have symmetric molecular structural formulas, so that the organic ketone (demulsifier) has high rigidity, to ensure that the working substance has a stable liquid-liquid interface.

A relationship between the stability of the flow visualization effect of the cold working substance and the boiling point of the demulsifier is considered. In a feasible implementation, n in 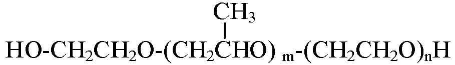 may be greater than or equal to 2, and m may be greater than or equal to 4, to ensure that 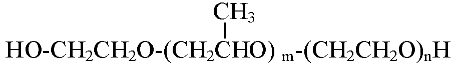 has a high boiling point, and further ensure that the working substance has a stable flow visualization effect.

A relationship between the demulsification efficiency of the demulsifier and the rigidity of the demulsifier is considered. In a feasible implementation, n may be less than or equal to 6, and m may be less than or equal to 10, so that 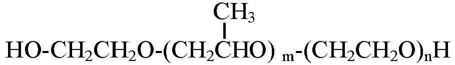 has high rigidity, to ensure that the working substance has a stable flow visualization effect. In a feasible implementation, n in 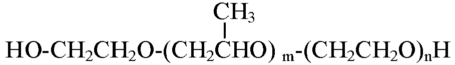 may range from 2 to 6, and m may range from 4 to 10.

In this way, the description of the demulsifier is completed.

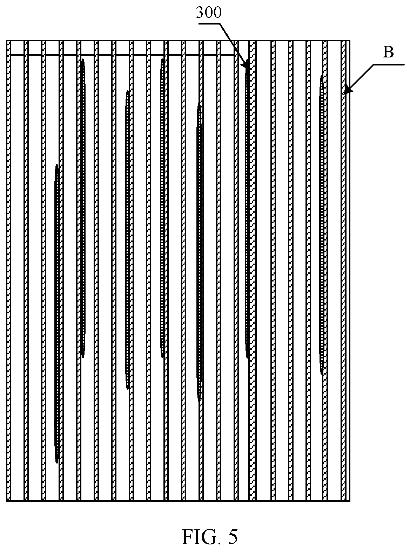

In an implementation in which the first medium includes water, the working substance may have a perfusion problem, causing the working substance to be attached to an inner wall of a cavity. Specifically, in a process of inj ecting the working substance into the inner wall of the cavity, the water in the working substance has large surface tension. As a result, it is difficult for the working substance to infiltrate the inner wall of the cavity, and the working substance is attached to the inner wall of the cavity, in other words, a wall hanging phenomenon occurs. Specifically, refer to FIG. 5. It can be learned that the working substance 300 is attached to an inner wall of an inner wall B of the cavity.

To resolve the perfusion problem of the working substance, in a feasible implementation, the working substance may further include a drag-reducing additive (drag-reducing additive).

The drag-reducing additive can reduce flow resistance of the first medium, so that the working substance transfers a large amount of heat per unit time, and the working substance can achieve a good temperature control function.

A type of auxiliary included in the drag-reducing additive is not specifically limited in embodiments of this application. Any auxiliary that can reduce the flow resistance of the first medium may be used as the drag-reducing additive in the working substance disclosed in embodiments of this application. In embodiments of this application, the drag-reducing additive can reduce surface tension of the first medium, improve wetting performance of the first medium on the inner wall of the cavity, and alleviate wall hanging of the working substance.

For example, the drag-reducing additive may include poly-α-olefin, poly(methyl methacrylate), polyacrylamide, polyethylene oxide, poly-α-octylene, poly-α-decene, cationic polyacrylamide, and the like.

It is considered that heat dissipation performance of the cold working substance is related to flexibility of the drag-reducing additive. Specifically, a greater relative molecular mass of the drag-reducing additive indicates a longer molecular chain of the drag-reducing additive, better flexibility of the drag-reducing additive, a more significant effect of reducing the flow resistance of the first medium by the drag-reducing additive, and better heat dissipation performance of the working substance.

To further improve the heat dissipation performance of the working substance, in a feasible implementation, the relative molecular mass of the drag-reducing additive may be greater than or equal to 2* 10⁵. For example, the relative molecular mass of the drag-reducing additive may include 5*10⁵, 1*10⁶, 5* 10⁶, and the like.

In this implementation, the relative molecular mass of the drag-reducing additive may be greater than or equal to 5* 10⁵. The drag-reducing additive has a large relative molecular mass, a long molecular chain, and high flexibility, and can greatly reduce flow resistance generated in a flowing process of the first medium, so that the first medium can transfer a large amount of heat per unit time, and the heat dissipation performance of the working substance is good.

In this way, the description of the working substance is completed.

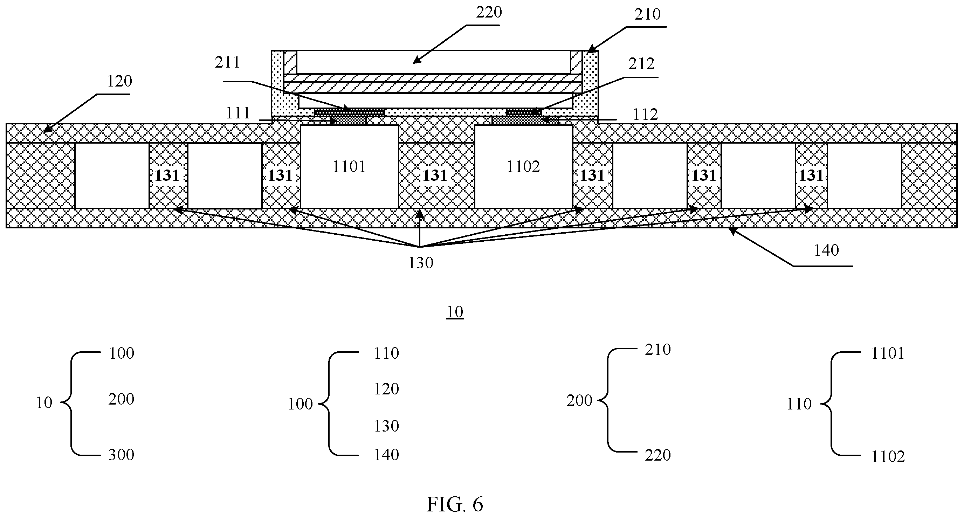

An embodiment of this application further discloses a liquid cooling module. Refer to FIG. 6. The liquid cooling module 10 may include a pump 200, a liquid cooling component 100, and a working substance (not shown in the figure). The working substance is filled in a cavity 110 of the liquid cooling component 100, and the pump 200 communicates with the cavity 110 of the liquid cooling component.

In a feasible implementation, the pump 200 may include a pump base 210, a piezoelectric component 220 connected to the pump base 210, and the like. The pump base 210 is provided with a pump liquid inlet 211 and a pump liquid outlet 212.

The liquid cooling component 100 is provided with a liquid cooling outlet 111 and a liquid cooling inlet 112. The liquid cooling outlet 111 is configured to communicate with the pump liquid inlet 211, and the liquid cooling inlet 112 is configured to communicate with the pump liquid outlet 212. A portion of the liquid cooling component 100 on a periphery of the liquid cooling outlet 111 and a portion of the pump base 210 on a periphery of the pump liquid inlet 211 form a sealing structure, to implement communication between the liquid cooling outlet 111 and the pump liquid inlet 211. A portion of the liquid cooling component 100 on a periphery of the liquid cooling inlet 112 and a portion of the pump base 210 on a periphery of the pump liquid outlet 212 form a sealing structure, to implement communication between the liquid cooling inlet 112 and the pump liquid outlet 212. In other words, the pump base 210 communicates with the cavity 110 of the liquid cooling component.

It should be noted that, in this embodiment of this application, that the liquid cooling outlet 111 is configured to communicate with the pump liquid inlet 211 does not mean that the liquid cooling outlet 111 is always in a communication state with the pump liquid inlet 211, but means that the working substance can flow into the pump liquid inlet 211 from the liquid cooling outlet 111 under a specific condition. A relationship between the liquid cooling inlet 112 and the pump liquid outlet 212 is similar to that described above.

It can be learned that the pump 200 (the pump base 210) in the liquid cooling module 10 disclosed in this implementation communicates with the cavity 110 of the liquid cooling component, and the pump 200 may be used as a power source to provide flowing power for the working substance 300 in the cavity of the liquid cooling component 100. The working substance 300 may be used as a medium for heat transfer in a flowing process, so that the liquid cooling component 100 can achieve a lasting heat dissipation effect.

How the portion of the liquid cooling component on the periphery of the liquid cooling outlet 111 and the portion of the pump base on the periphery of the pump liquid inlet 211 are connected to each other is not specifically limited in embodiments of this application.

In this feasible implementation, the portion of the liquid cooling component on the periphery of the liquid cooling outlet 111 and the portion of the pump base on the periphery of the pump liquid inlet 211 are of an integrated sealing structure, and the portion of the liquid cooling component on the periphery of the liquid cooling inlet 112 and the portion of the pump base on the periphery of the pump liquid outlet 212 are of an integrated sealing structure. Forming the integrated structure means that there are no continuous interfaces between two parts because of mutual integration and penetration, and the periphery of the liquid cooling outlet is an adjacent area around the liquid cooling outlet.

In this feasible implementation, the portion of the liquid cooling component on the periphery of the liquid cooling outlet 111 and the portion of the pump base on the periphery of the pump liquid inlet 211 are separated structures. The portion of the liquid cooling component on the periphery of the liquid cooling outlet 111 and the portion of the pump base on the periphery of the pump liquid inlet 211 are connected to each other through fastening using a screw, high-temperature adhesive bonding, UV adhesive photocuring bonding, thermo compression bonding and seal welding, thermo melt welding, ultrasonic welding, high frequency welding, and the like. Similarly, the portion of the liquid cooling component on the periphery of the liquid cooling inlet 112 and the portion of the pump base on the periphery of the pump liquid outlet 212 may be separated structures, and the portion of the liquid cooling component on the periphery of the liquid cooling inlet 112 and the portion of the pump base on the periphery of the pump liquid outlet 212 may be connected in the foregoing manner.

An elongation at break of the liquid cooling module 10 is increased to facilitate releasing and increasing stress of the liquid cooling module 10 during bending. In a feasible implementation, a surface energy difference between the portion of the liquid cooling component 100 on the periphery of the liquid cooling outlet 111 and the portion of the pump base 210 on the periphery of the pump liquid inlet 211 is less than or equal to 5 mN/m.

In this implementation, the surface energy difference between the portion of the liquid cooling component 100 on the periphery of the liquid cooling outlet 111 and the portion of the pump base 210 on the periphery of the pump liquid inlet 211 is less than or equal to 5 mN/m. A surface energy difference between the liquid cooling component 100 and the pump base 210 is small. Stress generated when the liquid cooling component 100 and the pump base 210 are bent can be released well, so that the liquid cooling component 100 and the pump base 210 have a high elongation at break.

Similarly, in a feasible implementation, a surface energy difference between the portion of the liquid cooling component 100 on the periphery of the liquid cooling inlet 112 and the portion of the pump base 210 on the periphery of the pump liquid outlet 212 is less than or equal to 5 mN/m.

In this embodiment of this application, the cavity 110 is provided inside the liquid cooling component 100. The working substance is filled in the cavity 110 of the liquid cooling component. The working substance disclosed in this embodiment of this application is used as the working substance. Specifically, the working substance may include a first medium and a second phase. A liquid-liquid interface exists between the first medium and the second phase. When the working substance moves under driving of the pump, the liquid-liquid interface of the working substance moves relative to the cavity, so that the working substance can present a flow visualization effect.

In this embodiment of this application, a visible light transmittance of at least a partial area of the liquid cooling component 100 is greater than or equal to a threshold, so that a flow visualization effect of the working substance 300 can be displayed through the liquid cooling component 100 in the area. In other words, the liquid cooling module 10 can achieve a visualization effect.

A value of the threshold is not specifically limited in embodiments of this application. For example, the threshold may be 70%, 80%, 90%, or the like.

In a feasible implementation, at least the partial area of the liquid cooling component 100 may be made of a transparent material, so that at least the partial area of the liquid cooling component 100 have a large visible light transmittance, and the liquid cooling module can achieve a significant visualization effect.

In this embodiment of this application, the transparent material may be understood as a material whose visible light transmittance is greater than the threshold in a band of 380 nm to 760 nm.

In a feasible implementation, the transparent material may include inorganic glass, polyethylene terephthalate (PET), polyethylene naphthalate (PEN), polypropylene (PP), cyclolefin copolymer (COC), polytetramethylpentene (PMP), polyimide (PI), poly(methyl methacrylate) (PMMA), polyphenylene sulfide (PPS), polyether ether ketone (PEEK), styrene-acrylonitrile copolymer (AS), acrylonitrile-butadiene-styrene copolymer (ABS), butadiene-styrene copolymer (BS), and the like.

The transparent material disclosed in this implementation has a large visible light transmittance, and the liquid cooling component 100 made of the foregoing material has a large visible light transmittance (in some implementations, the visible light transmittance of the liquid cooling component 100 may be 90% or more), so that the liquid cooling module 10 can achieve a significant flow visualization effect.

In some feasible implementations, a molecular structural formula of the transparent material may include but is not limited to: 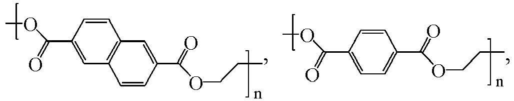 and the like.

In this implementation, the molecular structural formula of the transparent material includes an ether bond (-O-), and the ether bond may break a conjugate structure of a benzene ring in the molecular structural formula, so that the transparent material has a large visible light transmittance, the liquid cooling component 100 has a large visible light transmittance, and the liquid cooling module 10 can be ensured to achieve a significant flow visualization effect.

It is considered that thermal performance and mechanical performance of the liquid cooling component 100 are related to a relative molecular mass of the transparent material. Specifically, a greater relative molecular mass of the transparent material indicates better thermodynamic performance and mechanical performance of the transparent material.

To obtain the liquid cooling component 100 with good thermodynamic performance and mechanical performance, in a feasible implementation, n in 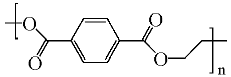 may be greater than or equal to 100, so that the transparent material whose molecular structural formula includes 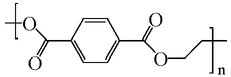 has good thermodynamic performance and mechanical performance. In this way, it is ensured that the liquid cooling component 100 obtained by using the transparent material has good thermodynamic performance and mechanical performance.

It is considered that visible light transmission performance of the liquid cooling component 100 is related to a quantity of conjugate structures in the molecular structural formula of the transparent material. Specifically, the conjugate structure has a charge-transfer complex (charge-transfer complex, CTC) effect between molecules and within a molecule, so that the transparent material presents color. Therefore, more conjugate structures included in the molecular structural formula of the transparent material indicates a lower visible light transmittance of the transparent material.

To obtain the liquid cooling component 100 with a large visible light transmittance, in a feasible implementation, n in 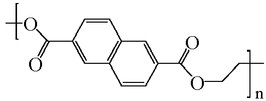 may be less than or equal to 200, so that the transparent material whose molecular structural formula includes 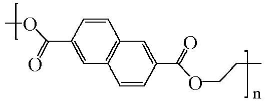 has a large visible light transmittance. In this way, it is ensured that the liquid cooling component 100 obtained by using the transparent material has a large visible light transmittance, and it is ensured that the liquid cooling module 10 can display a significant flow visualization effect.

To balance thermodynamic performance, mechanical performance, and visualization performance of the liquid cooling module, in a feasible implementation, n in 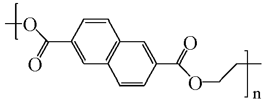 ranges from 100 to 200.

In a feasible implementation, n in 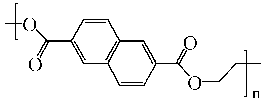 may be greater than or equal to 100. In a feasible implementation, n in 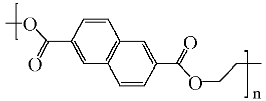 may be less than or equal to 200. In a feasible implementation, n in 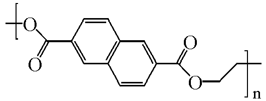 may range from 100 to 200.

In some feasible implementations, the molecular structural formula of the transparent material may include 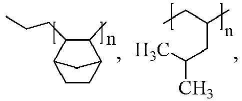 and the like.

In this implementation, the molecular structural formula of the transparent material includes 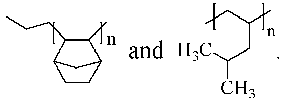 The transparent material has a small quantity of conjugate structures. Therefore, the transparent material has a large visible light transmittance, and the liquid cooling module can achieve a significant flow visualization effect.

It is considered that the thermal performance and mechanical performance of the liquid cooling component 100 are related to the relative molecular mass of the transparent material. Specifically, a greater relative molecular mass of the transparent material indicates better thermal performance and mechanical performance of the liquid cooling component 100 formed by using the transparent material.

In a feasible implementation, n in 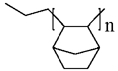 is greater than or equal to 200, so that the transparent material whose molecular structural formula includes 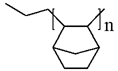 has good thermodynamic performance and mechanical performance. In this way, it is ensured that the liquid cooling component 100 obtained by using the transparent material has good thermodynamic performance and mechanical performance.

It is considered that bending performance of the liquid cooling component 100 is related to a distribution status of substituents in the transparent material. Specifically, a higher distribution density of the substituents in the molecular structural formula indicates worse flexibility of the transparent material. Correspondingly, bending performance of the liquid cooling component 100 formed by using the transparent material is worse, and bending performance of the liquid cooling module 10 is worse.

To ensure that the liquid cooling module has good bending performance, in a feasible implementation, n in 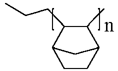 is less than or equal to 300. Herein, n in 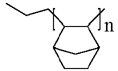 is less than or equal to 300. A small quantity of large-volume substituents 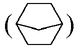 are distributed in the transparent material, and therefore, a distribution density of the large-volume substituents in the transparent material is small, and the transparent material has good flexibility. The liquid cooling component 100 formed by using the transparent material has good flexibility, to ensure that the liquid cooling module 10 has good bending performance.

In a feasible implementation, to balance thermodynamic performance, mechanical performance, and bending performance of the liquid cooling module 10, n in 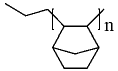 ranges from 200 to 300.

In a feasible implementation, n in 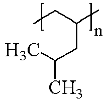 may be greater than or equal to 240. In a feasible implementation, n in 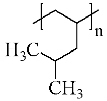 may be less than or equal to 340. In a feasible implementation, n in 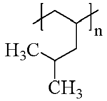 may range from 240 to 340.

It should be noted that, that the liquid cooling component 100 is formed by using the transparent material in the foregoing embodiment may be understood as that the transparent material forms at least a partial area of the liquid cooling component 100, so that at least the partial area of the liquid cooling component 100 has a large visible light transmittance.

Still refer to FIG. 6. In a feasible implementation, the liquid cooling component 100 may include a coverage layer 120, a flow channel layer 130, and a coverage layer 140 that are sequentially disposed. The coverage layer 120 is disposed on one side of the flow channel layer 130, the coverage layer 140 is disposed on the other side of the flow channel layer 130, and the cavity 110 is enclosed by the coverage layer 120, the flow channel layer 130, and the coverage layer 140. For ease of differentiation, in this embodiment of this application, the coverage layer 120 is referred to as a top coverage layer 120, and the coverage layer 140 is referred to as a bottom coverage layer 140.

In a feasible implementation, the flow channel layer 130 includes at least one rigid substrate 131. The rigid substrate 131 is disposed between the top coverage layer 120 and the bottom coverage layer 140, and is configured to support the top coverage layer 120 and the bottom coverage layer 140.

The rigid substrate 131 is further configured to separate a flow channel of the cavity 110 into at least one liquid inlet flow channel 1101 and at least one liquid outlet flow channel 1102, and both the liquid inlet flow channel 1101 and the liquid outlet flow channel 1102 are enclosed by the rigid substrate 131, the top coverage layer 120, and the bottom coverage layer 140. The liquid inlet flow channel 1101 is kept in a communication state with the liquid cooling inlet 112, and the liquid outlet flow channel 1102 is kept in a communication state with the liquid cooling outlet 111. The liquid inlet flow channel 1101 and the liquid outlet flow channel 1102 are separated by the rigid substrate 131. This helps avoid affecting a heat dissipation effect due to mixed flow of a cooling medium in the liquid inlet flow channel 1101 and the liquid outlet flow channel 1102.

In this feasible implementation, the top coverage layer 120, the rigid substrate 131, and the bottom coverage layer 140 may be of an integrated structure. In this way, the liquid inlet flow channel 1101 and the liquid outlet flow channel 1102 that are enclosed by the top coverage layer 120, the rigid substrate 131, and the bottom coverage layer 140 have a good sealing effect, to avoid a liquid (working substance 300) leakage problem.

It should be noted that, in an implementation in which the top coverage layer 120, the rigid substrate 131, and the bottom coverage layer 140 are of an integrated structure, the top coverage layer 120, the rigid substrate 131, and the bottom coverage layer 140 are all made of a transparent material, so that the liquid cooling module can achieve a flowable visualization effect.

In this feasible implementation, the top coverage layer 120, the rigid substrate 131, and the bottom coverage layer 140 may be separated structures. The top coverage layer 120, the rigid substrate 131, and the bottom coverage layer 140 may be connected to each other through fastening using a screw, high-temperature adhesive bonding, UV adhesive photocuring bonding, thermo compression bonding and seal welding, thermo melt welding, ultrasonic welding, high frequency welding, and the like. In this implementation, the top coverage layer 120, the rigid substrate 131, and the bottom coverage layer 140 may be made of a same material or different materials. However, it needs to be ensured that at least one of the top coverage layer 120 and the bottom coverage layer 140 is made of a transparent material.

In an implementation, a difference between a melting temperature of the coverage layer (120, 140) and a melting temperature of the rigid substrate 131 is less than or equal to 20°C. A smaller difference between the melting temperature of the coverage layer (120, 140) and the melting temperature of the rigid substrate 131 helps the coverage layer (120, 140) and the rigid substrate 131 form an integrated structure through seal welding, so that sealing effects of the liquid inlet flow channel 1101 and the liquid outlet flow channel 1102 are improved.

The seal welding may include a high-temperature connection manner without solder paste such as thermo compression bonding and seal welding, thermo melt welding, ultrasonic welding, high frequency welding, and the like. Thermo compression sealing is usually performed in a high-temperature environment. If a difference between a coefficient of thermal expansion of the coverage layer (120, 140) and a coefficient of thermal expansion of the rigid substrate 131 is large, the coverage layer (120, 140) and the rigid substrate 131 have warpage (warpage), so that a sealing effect of the liquid inlet flow channel 1101 and the liquid outlet flow channel 1102 that are enclosed by the coverage layer (120, 140) and the rigid substrate 131 is reduced.

To further improve the sealing effect of the liquid inlet flow channel 1101 and the liquid outlet flow channel 1102, in a feasible implementation, the difference between the coefficient of thermal expansion of the coverage layer (120, 140) and the coefficient of thermal expansion of the rigid substrate 131 is less than or equal to ≤ 10* 10⁻⁶/(°C).

In this implementation, the difference between the coefficient of thermal expansion of the coverage layer (120, 140) and the coefficient of thermal expansion of the rigid substrate 131 is less than or equal to ≤ 10* 10⁻⁶/°C. The difference between the coefficient of thermal expansion of the coverage layer (120, 140) and the coefficient of thermal expansion of the rigid substrate 131 is small, so that warpage of the coverage layer (120, 140) and the rigid substrate 131 in a sealed welding process can be reduced to a specific extent, and the liquid inlet flow channel 1101 and the liquid outlet flow channel 1102 that are enclosed by the coverage layer (120, 140) and the rigid substrate 131 are ensured to have a good sealing effect.

In a feasible implementation, a thickness of the coverage layer (120, 140) is less than 2 mm. In this implementation, the thickness of the coverage layer (120, 140) is less than or equal to less than 2 mm, so that a lightweight liquid cooling module 10 can be implemented. In addition, the liquid cooling module 10 with a significant flow visualization effect can be implemented.

To prevent an evaporation loss of the working substance during long-term operation from affecting reliability of the liquid cooling module, in a feasible implementation, an anti-evaporation layer is disposed on a surface of the coverage layer (120, 140). A location of the anti-evaporation layer is not specifically limited in embodiments of this application. In a feasible implementation, the anti-evaporation layer may be disposed on a side that is of the coverage layer (120, 140) and that is close to the working substance. In a feasible implementation, the anti-evaporation layer may be disposed on a side that is of the coverage layer (120 and 140) and that is away from the working substance.

In this embodiment of this application, a density of the anti-evaporation layer is greater than a density of the coverage layer. Disposing the anti-evaporation layer may increase difficulty for the working substance to escape from the cavity. In other words, the anti-evaporation layer reduces the evaporation loss of the working substance.

In addition, a visible light transmittance of the anti-evaporation layer is greater than or equal to a threshold, to ensure a flow visualization effect of the liquid cooling module.

A material used for the anti-evaporation layer is not specifically limited in embodiments of this application. Any material that can avoid the evaporation loss of the working substance may be used as a material of the anti-evaporation layer in embodiments of this application. For example, the material used for the anti-evaporation layer may include at least one of a polyimide layer, a polyvinyl chloride layer, or a metal film layer.

In this implementation, the anti-evaporation layer is disposed on the surface of the coverage layer (120, 140). The anti-evaporation layer can avoid the evaporation loss of the working substance, to ensure long-term reliability of the liquid cooling module. In addition, a visible light transmittance of the anti-evaporation layer is greater than or equal to a threshold, to ensure a flow visualization effect of the liquid cooling module.

The following describes, with reference to specific data, heat dissipation performance of the working substance disclosed in embodiments of this application.

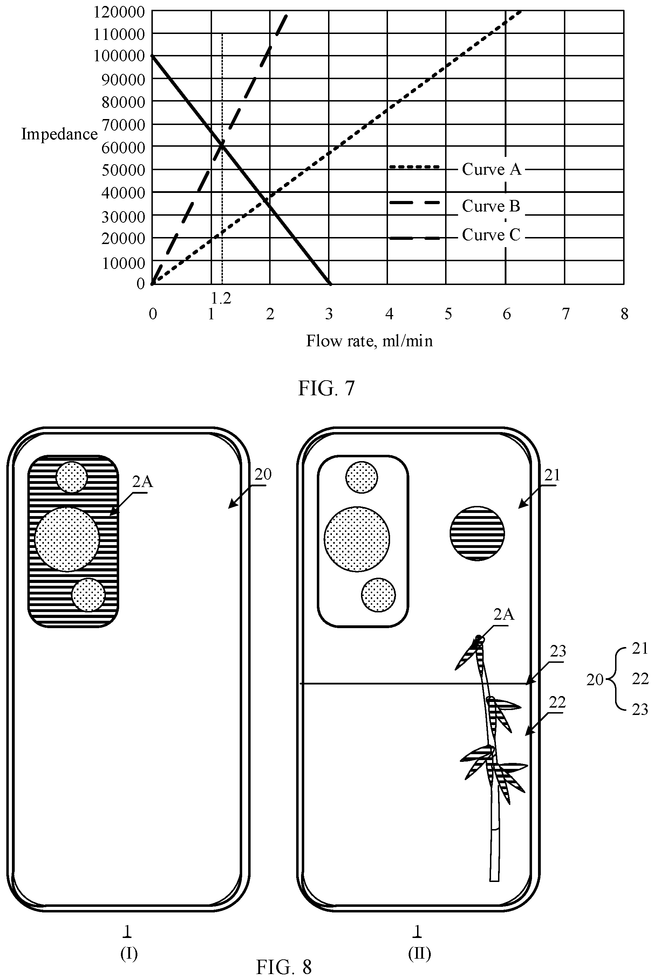

When the working substance disclosed in embodiments of this application is applied to the liquid cooling module, the working substance may have small impedance (flow resistance) and a large flow rate, so that the working substance has a stronger heat exchange capability and a higher equivalent thermal conductivity. Specifically, refer to FIG. 7. FIG. 7 shows a curve of a relationship between a flow rate Q and an impedance P (unit: Pa) that are of the liquid cooling module. A curve C is a pressure-flow rate curve, namely, a P-Q curve, of a pump in a liquid cooling system. A curve A is an impedance-flow rate P-Q data curve of the working substance (the first medium is water) disclosed in embodiments of this application, and an intersection point between the curve A and the curve C is an impedance-flow rate value during actual application. In this case, impedance at a working point is approximately 37000 KPa, and a flow rate at the working point is approximately 1.8 ml/min. A curve B is an impedance-flow rate P-Q data curve when the working substance (fluorinated liquid and light oil) is used. An intersection point between the curve B and the curve C is an impedance-flow rate value during actual application. In this case, impedance at the working point is approximately 60000 KPa, and the flow rate at the working point is approximately 1.2 ml/min. It can be learned that for a same pump and a same liquid cooling module, the mixed working substance disclosed in embodiments of this application has a low viscosity and impedance, and a higher flow rate and flow velocity, so that the mixed working substance has a lower temperature difference and a higher equivalent thermal conductivity.

For specific experiment results, refer to the following Table 1.

**Table 1**

| | Working substance disclosed in embodiments of this application | Fluorinated liquid and light oil | Fluorinated liquid and light oil |
|---|---|---|---|
| Thickness of the liquid cooling component | 0.2 mm | 0.2 mm | 0.33 mm |
| Pump (length*width*height) | 7 mm *7 mm *1.5 mm | 7 mm *7 mm *1.5 mm | 7*7*1.5 mm |
| Maximum temperature difference of the liquid cooling component | Approximately **3.7**°C@3.5 W | Approximately 14°C@3.5 W | Approximately 8.3°C@3.5 W |

Experimental conditions are as follows:
The working substance disclosed in embodiments of this application is applied to the liquid cooling module (the total thickness of the liquid cooling component is 0.2 mm). In an environment with a heat source of 3.5 W, a temperature difference between a hot end and a cold end of the liquid cooling module is approximately 3.7°C, and an equivalent thermal conductivity of the liquid cooling module is equivalent to that of a VC (vapor chamber) or heat pipe for two-phase heat exchange, which is greater than 5000 W/m-K and much higher than a thermal conductivity (< 800 W/m-K) of common copper-aluminum and natural graphite.

The working substance (fluorinated liquid and light oil) is applied to the liquid cooling module (the total thickness of the liquid cooling component is 0.2 mm). In an environment with a heat source of 3.5 W, a temperature difference between a hot end and a cold end of the liquid cooling module is approximately 14°C.

The working substance (fluorinated liquid and light oil) is applied to the liquid cooling module (the total thickness of the liquid cooling component is 0.33 mm). In an environment with a heat source of 3.5 W, a temperature difference between a hot end and a cold end of the liquid cooling module is approximately 8.3°C.

The following further describes the liquid cooling module disclosed in this embodiment of this application with reference to specific examples.

### Embodiment 1

For components of parts of the liquid cooling module disclosed in Embodiment 1, refer to Table 2.

**Table 2**

| | |
|---|---|
| Pump | Piezoelectric ceramic pump |
| Liquid cooling component | Transparent material: COC |
| Working substance | First medium: water |
| | Second phase: fluorinated liquid |
| | Second phase: thermally conductive oil |
| | Demulsifier: polyether siloxane (HLB=7) |
| | Demulsifier: cationic polyacrylamide |
| | Demulsifier: sodium alkyl naphthalate sulfonate |
| | Water-soluble dye: reactive orange |

In the liquid cooling module disclosed in Embodiment 1, the second phase includes fluorinated liquid and thermally conductive oil. Each of the fluorinated liquid and the thermally conductive oil may form a liquid-liquid interface with water, so that a flow status of the working substance has a visualization effect. The working substance further includes an inorganic dye: reactive orange. The reactive orange may be water-soluble to color the first medium, so that contrast between the first medium and the second phase is enhanced, and a flow visualization effect of the working substance is enhanced.

In the liquid cooling module, the working substance is packaged in the cavity of the liquid cooling component 100, and the liquid cooling component 100 is made of the transparent material COC. The liquid cooling component 100 has a large visible light transmittance. The flow visualization effect of the working substance may be displayed through the liquid cooling component 100. The liquid cooling module disclosed in Embodiment 1 has a flow visualization effect.

The first medium includes water with good heat dissipation performance, to ensure that the liquid cooling module has an excellent heat dissipation capability. After the liquid cooling module runs in the presence of a 50°C heat source, a temperature difference between points of the liquid cooling module is less than 5°C.

### Embodiment 2

For components of parts of the liquid cooling module disclosed in Embodiment 2, refer to Table 3.

**Table 3**

| | |
|---|---|
| Pump | Piezoelectric ceramic pump |
| Liquid cooling component | Transparent material: PET |
| Working substance | First medium: liquid metal |
| | First medium: water |
| | Second phase: silicone oil |
| | Demulsifier: fluorocarbon surfactant (HLB=5) |
| | N-pentanol |
| | Water-soluble dye: reactive purple |

A micro-pump liquid cooling module disclosed in Embodiment 2 and the liquid cooling module disclosed in Embodiment 1 have same parts, and each part has similar components. A difference lies in that the first medium in the liquid cooling module disclosed in Embodiment 2 further includes a liquid metal. Because the liquid metal is a good conductor of heat, a heat dissipation capability of the first medium including the liquid metal is further improved. Therefore, a heat dissipation capability of the liquid cooling module disclosed in Embodiment 2 is further improved.

### Embodiment 3

For components of parts of the liquid cooling module disclosed in Embodiment 3, refer to Table 4.

**Table 4**

| | |
|---|---|
| Pump | Piezoelectric ceramic pump |
| Liquid cooling component | Transparent material: PP |
| Working substance | First medium: water |
| | Second phase: thermally conductive oil |
| | Demulsifier: polyoxyethylene ether nonionic surfactant (HLB=4) |
| | Pentone |
| | Water-soluble dye: reactive blue |

The liquid cooling module disclosed in Embodiment 3 has a flow visualization effect and an excellent heat dissipation capability.

### Embodiment 4

For components of parts of the liquid cooling module disclosed in Embodiment 4, refer to Table 5.

**Table 5**

| | |
|---|---|
| Pump | Piezoelectric ceramic pump |
| Liquid cooling plate | Transparent material: PP |
| Working substance | First medium: liquid metal |
| | Second phase: silicone oil |
| | Demulsifier: fluorocarbon surfactant (HLB=9) |
| | Demulsifier: sodium naphthalate |
| | Water-soluble dye: reactive orange |

In the liquid cooling module disclosed in Embodiment 4, a fluorocarbon surfactant is added to the working substance, and the fluorocarbon surfactant can reduce surface tension of the first medium, so that difficulty in perfusion of the first medium is further reduced, and occurrence of a wall hanging problem of the first medium is reduced.

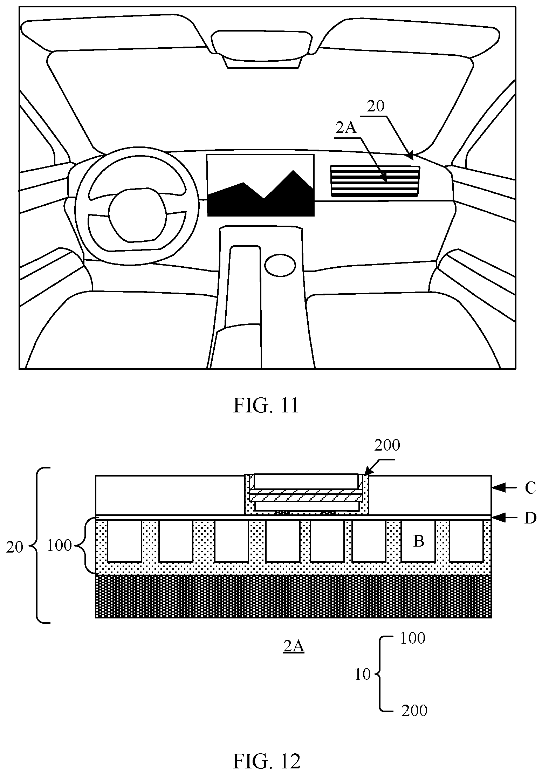

An embodiment of this application further discloses an electronic device. Refer to FIG. 8 to FIG. 12. The electronic device 1 may include the liquid cooling module 10 and the housing 20 disclosed in embodiments of this application. The liquid cooling module 10 is embedded in the housing 20, and a visible light transmittance of at least a partial area of the housing 20 is greater than or equal to a threshold. Refer to FIG. 12. An area C in which a visible light transmittance of the housing 20 is greater than or equal to the threshold at least partially overlaps an area D in which a visible light transmittance of the liquid cooling component 100 is greater than or equal to the threshold.

The housing 20 is located at an outermost layer of the electronic device 1, to protect another component.

The liquid cooling module 10 may include a liquid cooling component 100, a pump 200, and a working substance (not shown in the figure). The working substance may include a first medium and a second medium. The pump 200 is used as a power source for the working substance to drive the working substance to move. In a moving process of the working substance, a liquid-liquid interface moves relative to an inner wall of a cavity, to achieve a flow visualization effect.

An area in which a visible light transmittance of the housing 20 is greater than or equal to the threshold at least partially overlaps an area in which a visible light transmittance of the liquid cooling component 100 is greater than or equal to the threshold. In this way, a movable visualization effect of the working substance can be displayed through the area in which the visible light transmittance of the housing 20 is greater than or equal to the threshold and the area in which the visible light transmittance of the liquid cooling component 100 is greater than or equal to the threshold, that is, the electronic device can display a flow visualization effect.

In this embodiment of this application, an area in which the electronic device displays a flow visualization effect may be referred to as a flow visualization area 2A.

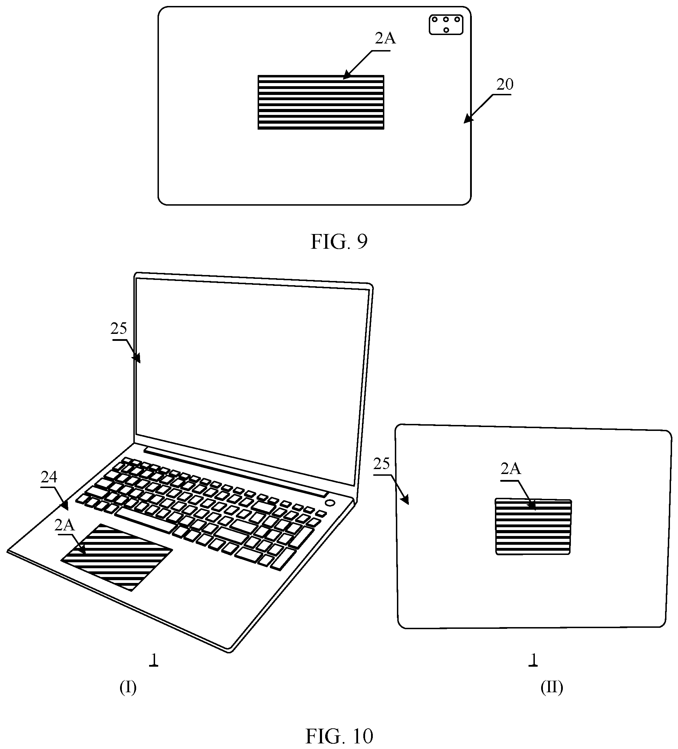

The electronic device disclosed in this embodiment of this application may include but is not limited to a mobile phone (FIG. 8), a tablet computer (FIG. 9), a notebook computer (FIG. 10), a vehicle-mounted device (FIG. 11), and the like.

The following further describes the electronic device disclosed in this embodiment of this application with reference to a specific example.

For example, refer to (I) in FIG. 8. The liquid cooling module 10 is embedded in an inner housing 20 of the mobile phone, and a visible light transmittance of the inner housing 20 of the mobile phone in the area 2A of a camera substrate is greater than or equal to the threshold. Through the area 2A, a liquid-liquid interface (not shown in the figure) of the working substance is displayed. The pump drives the working substance to move, so that the area 2A becomes the flow visualization area 2A.

For example, refer to (II) in FIG. 8. The liquid cooling module 10 is embedded in the inner housing 20 of the mobile phone, and a housing of the mobile phone includes a first non-folding part 21, a folding part 23, and a second non-folding part 22. A visible light transmittance of a partial area of the first non-folding part 21, a partial area of the folding part 23, and a partial area of the second non-folding part 22 is greater than or equal to the threshold (in a transparent area). The transparent area forms a cross-axis flow visualization area 2A.

For example, refer to FIG. 9. The liquid cooling module 10 is embedded in a housing 20 of the tablet computer, and a visible light transmittance of at least a partial area of the housing 20 of the tablet computer is greater than or equal to the threshold. A flow visualization area 2A is formed in the area.

For example, refer to FIG. 10. A housing of the notebook computer may include a body housing 24 and a display housing 25. Refer to (I) in FIG. 10. In some feasible implementations, the liquid cooling module 10 is embedded in the body housing 24, so that the body housing 24 may include a flow visualization area 2A.

Refer to (II) in FIG. 10. In some feasible implementations, the liquid cooling module 10 is embedded in the display housing 25, so that the display housing 25 may include a flow visualization area 2A.

For example, refer to FIG. 11. The liquid cooling module 10 may be embedded in a housing 20 of the vehicle-mounted device, so that the housing 20 of the vehicle-mounted device has a flow visualization area 2A.

It should be noted that, in an implementation in which the liquid cooling module is embedded in the housing, flow visualization areas with different shapes may be obtained by setting a shape of a light transmission area of the housing. This embodiment of this application merely describes several shapes of the flow visualization area as examples, and the foregoing shapes do not constitute a specific limitation.

An embodiment of this application further discloses an accessory, used in an electronic device. The accessory includes an accessory body, and the liquid cooling module disclosed in embodiments of this application. The liquid cooling module is embedded in the accessory body, and a visible light transmittance of at least a partial area of the accessory body is greater than or equal to a threshold. An area in which a visible light transmittance of the accessory body is greater than or equal to the threshold at least partially overlaps an area in which a visible light transmittance of the liquid cooling component is greater than or equal to the threshold. In this way, a flow visualization effect of the working substance in the liquid cooling module can be displayed through the accessory body in the area, that is, the area of the accessory becomes a flow visualization area.

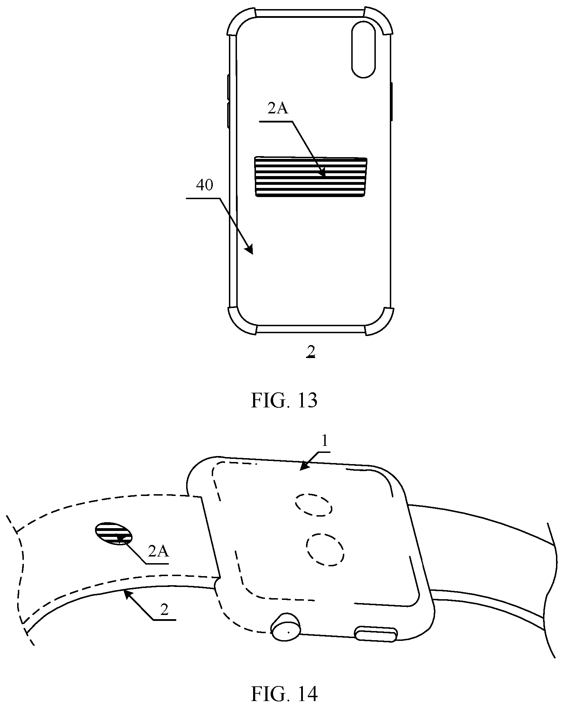

Refer to FIG. 13. FIG. 13 discloses a protective case. A protective case 2 may include an accessory body 40 and a liquid cooling module 10 embedded in the accessory body 40. A visible light transmittance of at least a partial area of the accessory body 40 is greater than or equal to a threshold, so that a flow visualization effect of the working substance can be displayed through the area, and the accessory has a flow display area 2A.

The accessory in this embodiment of this application may be understood as a part used together with an electronic device, and is a part disposed outside a housing. For example, the accessory may include but is not limited to a wrist strap and a protective case.

The following describes an application scenario of the accessory with reference to a specific example.

For example, refer to FIG. 14. FIG. 14 is a diagram of assembly of a wearable device 1 and a wrist strap 2 (an accessory). The wrist strap 2 is connected to the wearable device 1, so that the wearable device 1 can be sleeved on a target object. A liquid cooling module may be disposed in the wrist strap, so that the wrist strap has a flow visualization area 2A.

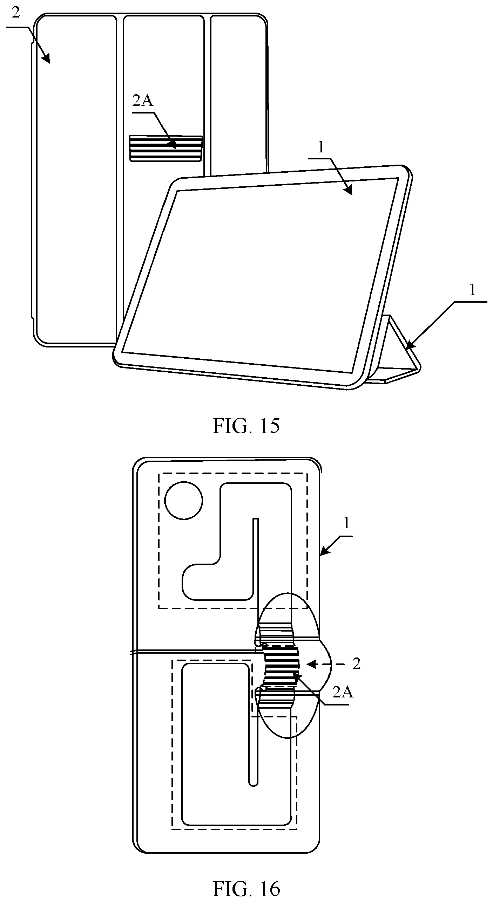

For example, refer to FIG. 15. FIG. 15 is a diagram of assembly of a tablet computer 1 and the protective case 2 (an accessory). The protective case 2 may be sleeved outside the tablet computer 1, to protect the tablet computer 1. A liquid cooling module may be disposed in the protective case 2, so that the protective case 2 has a flow visualization area 2A.

For example, refer to FIG. 16. FIG. 16 is a diagram of assembly of a mobile phone 1 and a connector 2 (an accessory). The connector 2 is connected to the mobile phone. A liquid cooling module may be disposed in the connector 2, so that the connector 2 has a flow visualization area 2A.

An example of this application further discloses a working substance preparation method, including: measuring a first medium and a second medium; and mixing the first medium and the second medium to obtain a working substance.

The working substance, the liquid cooling module, and the electronic device provided in embodiments of this application are described in detail above. The principle and embodiments of this specification are described herein with specific examples. The descriptions about the foregoing embodiments are merely provided to help understand the method and core ideas of this application. In addition, a person of ordinary skill in the art can make modifications to specific embodiments and application scopes according to the ideas of this application. Therefore, in conclusion, the content of this specification shall not be construed as a limitation on this application.

## Claims

1. A liquid cooling module, comprising:
a liquid cooling component, wherein the liquid cooling component comprises a cavity, and a visible light transmittance of at least a partial area of the liquid cooling component is greater than or equal to a threshold;
a working substance, wherein the working substance is disposed in the cavity, the working substance comprises a first medium and a second phase, and a liquid-liquid interface exists between the second phase and the first medium; and
a pump, wherein the pump communicates with the cavity, and the pump is configured to drive the working substance in the cavity to flow, so that the liquid-liquid interface moves relative to the cavity.

2. The liquid cooling module according to claim 1, wherein the first medium comprises at least one of water and a liquid metal.

3. The liquid cooling module according to claim 1 or 2, further comprising a water-soluble dye, wherein solubility of the water-soluble dye in the first medium is greater than solubility of the water-soluble dye in the second phase.

4. The liquid cooling module according to any one of claims 1 to 3, wherein in an environment of 25°C, a thermal conductivity of the first medium is greater than or equal to 0.1 W/m·k.

5. The liquid cooling module according to any one of claims 1 to 4, wherein in the environment of 25°C, a specific heat capacity of the first medium is greater than or equal to 1000 J/kg·°C.

6. The liquid cooling module according to any one of claims 1 to 5, wherein in the environment of 25°C, a viscosity of the first medium is less than or equal to 50 cp.

7. The liquid cooling module according to any one of claims 1 to 6, wherein a mass fraction of the first medium in the working substance is greater than or equal to 80%.

8. The liquid cooling module according to any one of claims 1 to 7, wherein the second phase comprises at least one second medium.

9. The liquid cooling module according to claim 8, wherein at least two second media are miscible with each other.

10. The liquid cooling module according to claim 8, wherein a liquid-liquid interface exists between any two second media.

11. The liquid cooling module according to any one of claims 1 to 10, wherein the working substance further comprises an organic dye, and solubility of the organic dye in the second phase is greater than solubility of the organic dye in the first medium.

12. The liquid cooling module according to any one of claims 1 to 11, wherein the working substance further comprises a drag-reducing additive; and
the drag-reducing additive is used to reduce flow resistance of the first medium.

13. The liquid cooling module according to claim 12, wherein the drag-reducing additive comprises at least one of poly-α-olefin, poly(methyl methacrylate), polyacrylamide, polyethylene oxide, poly-α-octylene, poly-α-decene, and cationic polyacrylamide.

14. The liquid cooling module according to claim 12 or 13, wherein a relative molecular mass of the drag-reducing additive is greater than or equal to 2*10⁵.

15. The liquid cooling module according to any one of claims 1 to 14, further comprising a demulsifier, wherein the demulsifier is used to break an emulsion formed by the first medium and the second phase.

16. The liquid cooling module according to claim 15, wherein the demulsifier comprises at least one of sodium alkyl naphthalate sulfonate, sodium alkane sulfonate, naphthenate, polyoxyethylene-polyoxypropylene copolymer, organic alcohol, and organic ketone.

17. The liquid cooling module according to claim 16, wherein a molecular structural formula of the sodium alkyl naphthalate sulfonate comprises: 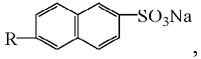 wherein R comprises a lipophilic group.

18. The liquid cooling module according to claim 16, wherein a molecular structural formula of the naphthenate comprises: 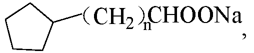 wherein n in 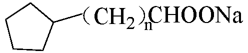 ranges from 3 to 12.

19. The liquid cooling module according to claim 16, wherein a molecular structural formula of the organic alcohol comprises:
at least one of

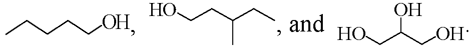

20. The liquid cooling module according to claim 16, wherein a molecular structural formula of the organic ketone comprises:
at least one of

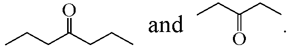

21. The liquid cooling module according to any one of claims 15 to 20, wherein a hydrophilic lipophilic balance of the demulsifier ranges from 1 to 20.

22. The liquid cooling module according to any one of claims 1 to 21, wherein the liquid cooling component comprises a flow channel layer and at least two coverage layers, wherein one coverage layer is disposed on one side of the flow channel layer, the other coverage layer is disposed on the other side of the flow channel layer, the cavity is enclosed by the coverage layers and the flow channel layer, and a visible light transmittance of at least one coverage layer is greater than or equal to the threshold.

23. The liquid cooling module according to claim 22, wherein a difference between a melting temperature of the flow channel layer and a melting temperature of the coverage layer is less than or equal to 20°C.

24. The liquid cooling module according to claim 22 or 23, wherein a difference between a coefficient of thermal expansion of the flow channel layer and a coefficient of thermal expansion of the coverage layer is less than or equal to 10*10⁻⁶/°C.

25. The liquid cooling module according to any one of claims 22 to 24, wherein a thickness of the coverage layer is less than or equal to 2 mm.

26. The liquid cooling module according to any one of claims 22 to 25, wherein at least one coverage layer is made of a transparent material, and the transparent material comprises at least one of inorganic glass, polyethylene terephthalate, polyethylene naphthalate, polypropylene, cyclo-olefin copolymer, polytetramethylpentene, polyimide, poly(methyl methacrylate), polyphenylene sulfide, polyether ether ketone, styrene-acrylonitrile copolymer, acrylonitrile-butadiene-styrene copolymer, and butadiene-styrene copolymer.

27. The liquid cooling module according to claim 26, wherein a molecular structural formula of the transparent material comprises:
at least one of 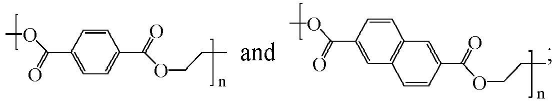 and
n in 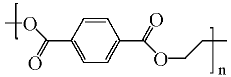 ranges from 100 to 200, and n in 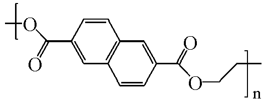 ranges from 100 to 200.

28. The liquid cooling module according to claim 26, wherein a molecular structural formula of the transparent material comprises:
at least one of 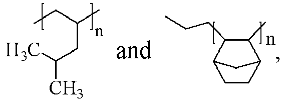 wherein n in 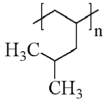 ranges from 240 to 340, and n in 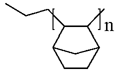 ranges from 200 to 300.

29. The liquid cooling module according to any one of claims 22 to 28, further comprising an anti-evaporation layer, wherein the anti-evaporation layer is disposed on a surface of the coverage layer, a density of the anti-evaporation layer is greater than a density of the coverage layer, and a visible light transmittance of the anti-evaporation layer is greater than or equal to the threshold.

30. An electronic device, comprising a housing and the liquid cooling module according to any one of claims 1 to 29, wherein
the liquid cooling module is embedded in the housing, a visible light transmittance of at least a partial area of the housing is greater than or equal to a threshold, and an area in which a visible light transmittance of the housing is greater than or equal to the threshold at least partially overlaps an area in which a visible light transmittance of the liquid cooling component is greater than or equal to the threshold.

31. An accessory, used in an electronic device, and comprising an accessory body and the liquid cooling module according to any one of claims 1 to 29, wherein the liquid cooling module is embedded in the accessory body; and an area in which a visible light transmittance of the accessory body is greater than or equal to a threshold at least partially overlaps an area in which a visible light transmittance of the liquid cooling component is greater than or equal to the threshold.
